# EUROPEAN PATENT APPLICATION

(11) **EP 4 852 645 A1**
(43) Date of publication of application: **09.12.2026**
(21) Application number: 26160617.2
(22) Date of filing: 25.02.2026
(51) Int. Cl.: H10D 62/10, H10D 30/01, H10D 30/00, H10D 30/67, H10D 64/23, H10D 84/01, H10D 84/83, H10D 84/85, H10D 88/00

(54) **SEMICONDUCTOR DEVICE INCLUDING A SOURCE/DRAIN CONTACT**

(30) Priority: 02.06.2025 KR 20250071905
(71) Applicant: Samsung Electronics Co., Ltd., Suwon-si, Gyeonggi-do 16677 (KR)
(72) Inventor: SON, Soo Min, 16677 Suwon-si, Gyeonggi-do (KR); YANG, Suk, 16677 Suwon-si, Gyeonggi-do (KR); LEE, Do Hyeon, 16677 Suwon-si, Gyeonggi-do (KR); LEE, Sang Moon, 16677 Suwon-si, Gyeonggi-do (KR); HAN, Soo Bin, 16677 Suwon-si, Gyeonggi-do (KR)
(74) Representative: Kuhnen & Wacker Patent- und Rechtsanwaltsbüro PartG mbB

(57) **Abstract**

An example semiconductor device includes a first plurality of lower nanosheets (BNW1), a second plurality of lower nanosheets (BNW2), a first nanosheet separation layer (NS1) on the first plurality of lower nanosheets (BNW1), a second nanosheet separation layer (NS2) on the second plurality of lower nanosheets (BNW2), a first plurality of upper nanosheets (UNW1) on an upper surface of the first nanosheet separation layer (NS1), a second plurality of upper nanosheets (UNW2) on an upper surface of the second nanosheet separation layer (NS2), a lower source/drain region (BSD1) between the first plurality of lower nanosheets (BNW1) and the second plurality of lower nanosheets (BNW2), an upper source/drain region (USD1) between the first plurality of upper nanosheets (UNW1) and the second plurality of upper nanosheets (UNW2), a first upper interlayer insulating layer (145) between the first and second nanosheet separation layers (NS1, NS2), and a source/drain contact (CA1) extending into the upper source/drain region (USD1) by passing through the lower source/drain region (BSD1) and the first upper interlayer insulating layer (145).

## Description

### BACKGROUND

As one of the scaling techniques for increasing a density of an integrated circuit device, a multi-gate transistor for forming a silicon body of a fin or nanowire shape on a substrate and forming a gate on a surface of the silicon body has been suggested.

Since this multi-gate transistor uses a three-dimensional channel, it is easy to scale the multi-gate transistor. Also, even though a gate length of the multi-gate transistor is not increased, a current control capability may be improved. In addition, a short channel effect (SCE) in which a potential of a channel region is affected by a drain voltage may be suppressed effectively.

### SUMMARY

The present disclosure relates to a semiconductor device that includes a Multi-Bridge Channel Field Effect Transistor (MBCFET^{™}).

An object of the present disclosure is to provide a semiconductor device in which, in a structure in which an NMOS transistor is stacked on a PMOS transistor, a source/drain contact connected to a source/drain region of the NMOS transistor by passing through a source/drain region of the PMOS transistor is formed to improve reliability in connection between the source/drain region of the PMOS transistor and the source/drain contact.

Another object of the present disclosure is to provide a semiconductor device in which, in a structure in which an NMOS transistor is stacked on a PMOS transistor, a source/drain contact connected to a source/drain region of the NMOS transistor by passing through a source/drain region of the PMOS transistor is formed to reduce occurrence of a short between the source/drain contact and a gate electrode.

The objects of the present disclosure are not limited to those mentioned above and additional objects of the present disclosure, which are not mentioned herein, will be clearly understood by those skilled in the art from the following description of the present disclosure.

In some implementations, a semiconductor device comprises a first plurality of lower nanosheets stacked to be spaced apart from each other in a vertical direction, a second plurality of lower nanosheets stacked to be spaced apart from each other in the vertical direction, the second plurality of lower nanosheets spaced apart from the first plurality of lower nanosheets in a first horizontal direction, a first nanosheet separation layer disposed on the first plurality of lower nanosheets, the first nanosheet separation layer including a first insulating material, a second nanosheet separation layer disposed on the second plurality of lower nanosheets, the second nanosheet separation layer spaced apart from the first nanosheet separation layer in the first horizontal direction, the second nanosheet separation layer including a second insulating material, a first plurality of upper nanosheets stacked to be spaced apart from each other in the vertical direction on an upper surface of the first nanosheet separation layer, a second plurality of upper nanosheets spaced apart from each other in the vertical direction on an upper surface of the second nanosheet separation layer, the second plurality of upper nanosheets spaced apart from the first plurality of upper nanosheets in the first horizontal direction, a lower source/drain region disposed between the first plurality of lower nanosheets and the second plurality of lower nanosheets, an upper source/drain region disposed between the first plurality of upper nanosheets and the second plurality of upper nanosheets, the upper source/drain region spaced apart from the lower source/drain region in the vertical direction, a first upper interlayer insulating layer disposed between the first nanosheet separation layer and the second nanosheet separation layer, and a source/drain contact extending into the upper source/drain region by passing through the lower source/drain region and the first upper interlayer insulating layer in the vertical direction, the source/drain contact electrically connected to each of the lower source/drain region and the upper source/drain region.

In some implementations, a semiconductor device comprises a lower interlayer insulating layer, an insulating pattern extending in a first horizontal direction on an upper surface of the lower interlayer insulating layer, a plurality of lower nanosheets stacked to be spaced apart from each other in a vertical direction on an upper surface of the insulating pattern, a nanosheet separation layer disposed on the plurality of lower nanosheets, the nanosheet separation layer including an insulating material, a plurality of upper nanosheets stacked to be spaced apart from each other in the vertical direction on an upper surface of the nanosheet separation layer, a gate electrode extending in a second horizontal direction different from the first horizontal direction on the upper surface of the insulating pattern, the gate electrode surrounding each of the plurality of lower nanosheets, the nanosheet separation layer and the plurality of upper nanosheets, a lower source/drain region disposed on one side of the gate electrode on the upper surface of the insulating pattern, an upper source/drain region disposed on the one side of the gate electrode, the upper source/drain region spaced apart from an upper surface of the lower source/drain region in the vertical direction, a first upper interlayer insulating layer disposed on a sidewall of the nanosheet separation layer in the first horizontal direction, the first upper interlayer insulating layer disposed between the upper surface of the lower source/drain region and a lower surface of the upper source/drain region, and a source/drain contact extending into the upper source/drain region by passing through the lower source/drain region and the first upper interlayer insulating layer in the vertical direction, the source/drain contact electrically connected to each of the lower source/drain region and the upper source/drain region.

In some implementations, a semiconductor device comprises a lower interlayer insulating layer, an insulating pattern extending in a first horizontal direction on an upper surface of the lower interlayer insulating layer, a first plurality of lower nanosheets stacked to be spaced apart from each other in a vertical direction on an upper surface of the insulating pattern, a second plurality of lower nanosheets stacked to be spaced apart from each other in the vertical direction on the upper surface of the insulating pattern, the second plurality of lower nanosheets spaced apart from the first plurality of lower nanosheets in the first horizontal direction, a first nanosheet separation layer disposed on the first plurality of lower nanosheets, the first nanosheet separation layer including an insulating material, a second nanosheet separation layer disposed on the second plurality of lower nanosheets, the second nanosheet separation layer spaced apart from the first nanosheet separation layer in the first horizontal direction, the second nanosheet separation layer including an insulating material, a first plurality of upper nanosheets stacked to be spaced apart from each other in the vertical direction on an upper surface of the first nanosheet separation layer, a second plurality of upper nanosheets stacked to be spaced apart from each other in the vertical direction on an upper surface of the second nanosheet separation layer, the second plurality of upper nanosheets spaced apart from the first plurality of upper nanosheets in the first horizontal direction, a first gate electrode extending in a second horizontal direction different from the first horizontal direction on the upper surface of the insulating pattern, the first gate electrode surrounding each of the first plurality of lower nanosheets, the first nanosheet separation layer and the first plurality of upper nanosheets, a second gate electrode extending in the second horizontal direction on the upper surface of the insulating pattern, the second gate electrode surrounding each of the second plurality of lower nanosheets, the second nanosheet separation layer and the second plurality of upper nanosheets, the second gate electrode spaced apart from the first gate electrode in the first horizontal direction, a lower source/drain region disposed between the first plurality of lower nanosheets and the second plurality of lower nanosheets, an upper source/drain region disposed between the first plurality of upper nanosheets and the second plurality of upper nanosheets, the upper source/drain region spaced apart from the lower source/drain region in the vertical direction, an upper interlayer insulating layer disposed between the first nanosheet separation layer and the second nanosheet separation layer, an etching stop layer disposed between a sidewall of each of the first and second nanosheet separation layers in the first horizontal direction and the upper interlayer insulating layer, and a source/drain contact extending into the upper source/drain region by passing through the lower source/drain region and the upper interlayer insulating layer in the vertical direction, the source/drain contact separating the lower source/drain region in the first horizontal direction, the source/drain contact electrically connected to each of the lower source/drain region and the upper source/drain region.

### BRIEF DESCRIPTION OF THE DRAWINGS

The above and other aspects and features of the present disclosure will become more apparent by describing in detail implementations thereof with reference to the attached drawings.
FIG. 1 is a schematic layout view illustrating an example of a semiconductor device.
FIG. 2 is an example cross-sectional view taken along line A-A' of FIG. 1.
FIG. 3 is an example cross-sectional view taken along line B-B' of FIG. 1.
FIG. 4 is an example cross-sectional view taken along line C-C' of FIG. 1.
FIGS. 5, 6, 7, 8, 9, 10, 11, 12, 13, 14, 15, 16, 17, 18, 19, 20, 21, 22, 23, 24, 25, 26, 27, 28, 29, 30, 31, 32, 33, and 34 are views illustrating intermediate steps to describe an example of a method for fabricating a semiconductor device.
FIGS. 35 and 36 are cross-sectional views illustrating an example of a semiconductor device.
FIGS. 37 and 38 are cross-sectional views illustrating an example of a semiconductor device.
FIG. 39 is a schematic layout view illustrating an example of a semiconductor device.
FIG. 40 is an example cross-sectional view taken along line E-E' of FIG. 39; and
FIGS. 41 and 42 are cross-sectional views illustrating an example of a semiconductor device.

### DETAILED DESCRIPTION

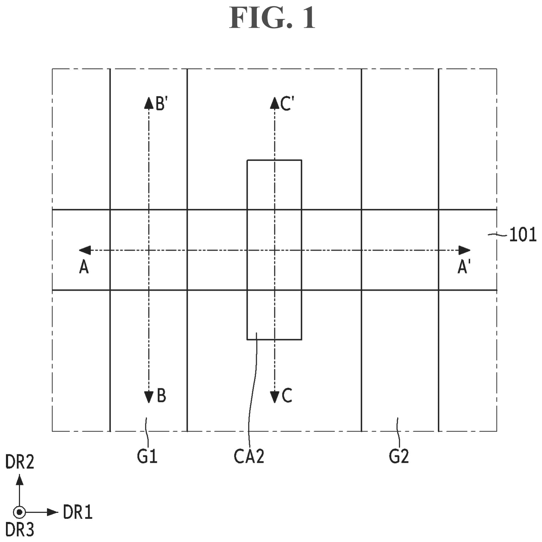

Hereinafter, a semiconductor device according to some implementations of the present disclosure will be described with reference to FIGS. 1 to 4.

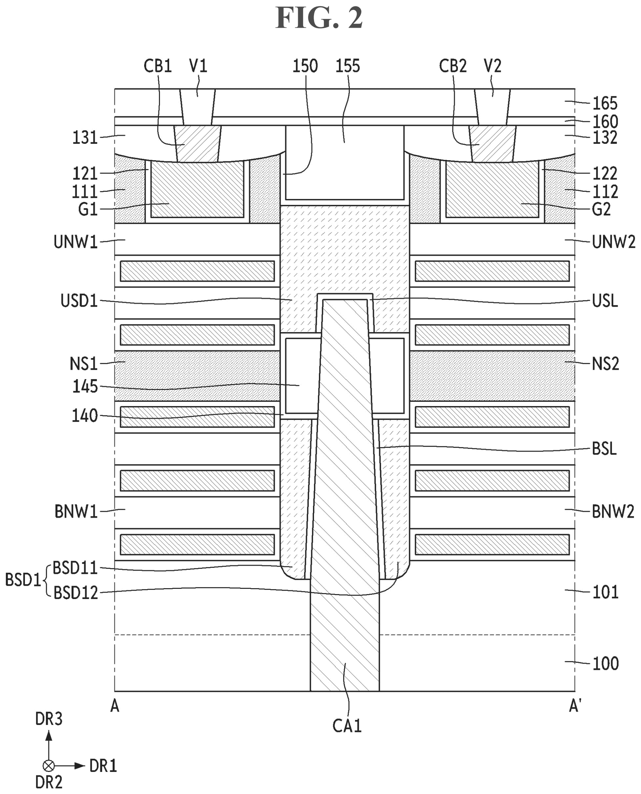

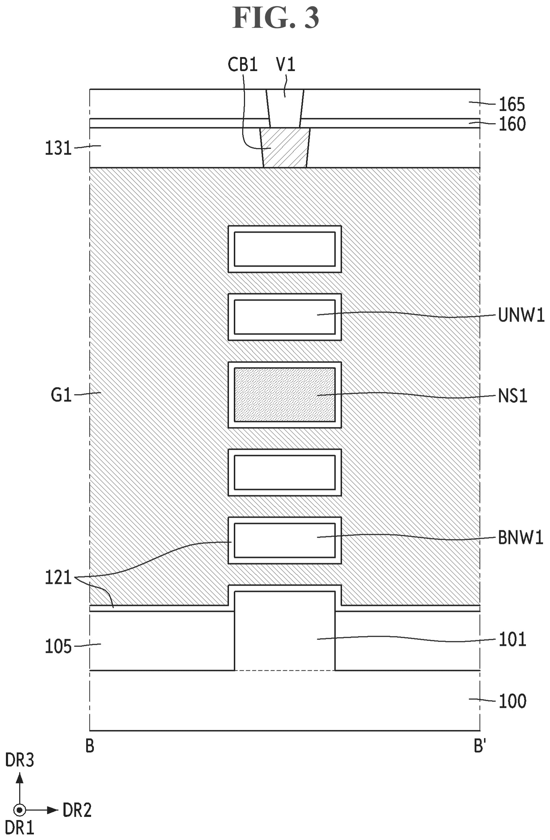

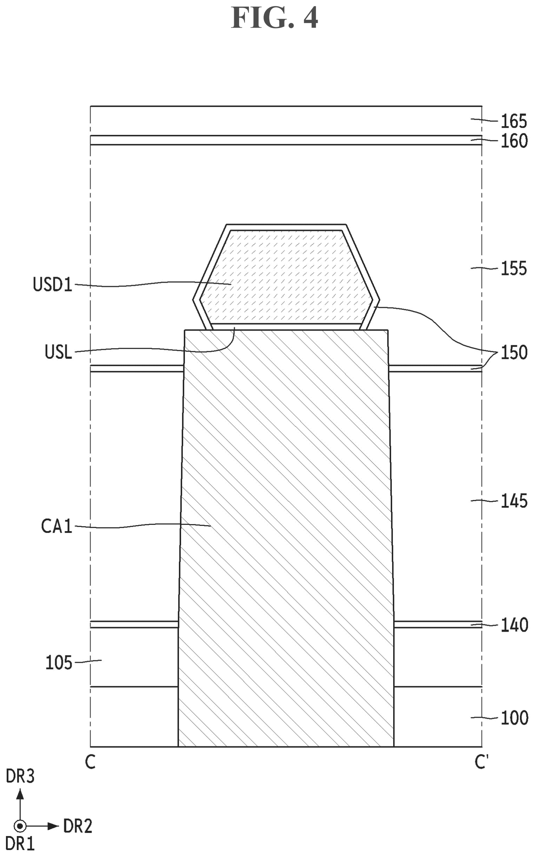

FIG. 1 is a schematic layout view illustrating an example of a semiconductor device. FIG. 2 is an example cross-sectional view taken along line A-A' of FIG. 1. FIG. 3 is an example cross-sectional view taken along line B-B' of FIG. 1. FIG. 4 is an example cross-sectional view taken along line C-C' of FIG. 1.

Referring to FIGS. 1 to 4, the semiconductor device includes a lower interlayer insulating layer 100, an insulating pattern 101, a field insulating layer 105, first and second plurality of lower nanosheets BNW1 and BNW2, first and second nanosheet separation layers NS1 and NS2, first and second plurality of upper nanosheets UNW1 and UNW2, first and second gate electrodes G1 and G2, first and second gate spacers 111 and 112, first and second gate insulating layers 121 and 122, first and second capping patterns 131 and 132, a lower source/drain region BSD1, an upper source/drain region USD1, a first etching stop layer 140, a first upper interlayer insulating layer 145, a second etching stop layer 150, a second upper interlayer insulating layer 155, a source/drain contact CA1, a lower silicide layer BSL, an upper silicide layer USL, first and second gate contacts CB1 and CB2, a third etching stop layer 160, a third upper interlayer insulating layer 165, and first and second vias V1 and V2.

The lower interlayer insulating layer 100 may include at least one of, for example, silicon oxide, silicon nitride, silicon oxynitride, or a low dielectric constant material. The low dielectric constant material may include, for example, Fluorinated TetraEthylOrthoSilicate (FTEOS), Hydrogen SilsesQuioxane (HSQ), Bis-benzoCycloButene (BCB), TetraMethylOrthoSilicate (TMOS), OctaMethylCycloTetraSiloxane (OMCTS), HexaMethylDiSiloxane (HMDS), TriMethylSilyl Borate (TMSB), DiAcetoxyDitertiaryButoxySiloxane (DADBS), TriMethylSilyl Phosphate (TMSP), PolyTetraFluoroEthylene (PTFE), Tonen SilaZen (TOSZ), Fluoride Silicate Glass (FSG), polyimide nanofoams such as polypropylene oxide, Carbon Doped silicon Oxide (CDO), Organo Silicate Glass (OSG), SiLK, Amorphous Fluorinated Carbon, silica aerogels, silica xerogels, mesoporous silica or their combination, but of the present disclosure are not limited thereto.

Hereinafter, each of a first horizontal direction DR1 and a second horizontal direction DR2 may be defined as a direction parallel with an upper surface of the lower interlayer insulating layer 100. The second horizontal direction DR2 may be defined as a direction different from the first horizontal direction DR1. A vertical direction DR3 may be defined as a direction perpendicular to each of the first horizontal direction DR1 and the second horizontal direction DR2. That is, the vertical direction DR3 may be defined as a direction perpendicular to the upper surface of the lower interlayer insulating layer 100.

The insulating pattern 101 may extend in the first horizontal direction DR1 on the upper surface of the lower interlayer insulating layer 100. The insulating pattern 101 may protrude from the upper surface of the lower interlayer insulating layer 100 in the vertical direction DR3. The insulating pattern 101 may include an insulating material. For example, the insulating pattern 101 may include the same material as that of the lower interlayer insulating layer 100. The field insulating layer 105 may be disposed on the upper surface of the lower interlayer insulating layer 100. The field insulating layer 105 may surround sidewalls of the insulating pattern 101. For example, an upper surface of the insulating pattern 101 may be formed to be higher than an upper surface of the field insulating layer 105. That is, at least a portion of the insulating pattern 101 may more protrude in the vertical direction DR3 than the upper surface of the field insulating layer 105, but of the present disclosure are not limited thereto. In some implementations, the upper surface of the insulating pattern 101 may be formed on the same plane as the upper surface of the field insulating layer 105. For example, the field insulating layer 105 may include an oxide film, a nitride film, an oxynitride film, or their combination film.

The first plurality of lower nanosheets BNW1 may be disposed on the upper surface of the insulating pattern 101. The first plurality of lower nanosheets BNW1 may include a plurality of nanosheets stacked to be spaced apart from each other in the vertical direction DR3 on the upper surface of the insulating pattern 101. For example, a lower surface of the lowermost nanosheet of the first plurality of lower nanosheets BNW1 may be spaced apart from the upper surface of the insulating pattern 101 in the vertical direction DR3. The second plurality of lower nanosheets BNW2 may be disposed on the upper surface of the insulating pattern 101. The second plurality of lower nanosheets BNW2 may be spaced apart from the first plurality of lower nanosheets BNW1 in the first horizontal direction DR1. The second plurality of lower nanosheets BNW2 may include a plurality of nanosheets stacked to be spaced apart from each other in the vertical direction DR3 on the upper surface of the insulating pattern 101. For example, a lower surface of the lowermost nanosheet of the second plurality of lower nanosheets BNW2 may be spaced apart from the upper surface of the insulating pattern 101 in the vertical direction DR3.

Although FIG. 2 and FIG. 3 illustrate that each of the first and second plurality of lower nanosheets BNW1 and BNW2 includes two nanosheets stacked in the vertical direction DR3, of the present disclosure are not limited thereto. In some implementations, each of the first and second plurality of lower nanosheets BNW1 and BNW2 may include three or more nanosheets stacked in the vertical direction DR3. For example, each of the first and second plurality of lower nanosheets BNW1 and BNW2 may include silicon (Si), but of the present disclosure are not limited thereto. In some implementations, each of the first and second plurality of lower nanosheets BNW1 and BNW2 may include silicon germanium (SiGe).

The first nanosheet separation layer NS1 may be disposed on the first plurality of lower nanosheets BNW1. For example, the first nanosheet separation layer NS1 may be spaced apart from an upper surface of the uppermost nanosheet of the first plurality of lower nanosheets BNW1 in the vertical direction DR3. The second nanosheet separation layer NS2 may be disposed on the second plurality of lower nanosheets BNW2. The second nanosheet separation layer NS2 may be spaced apart from the first nanosheet separation layer NS1 in the first horizontal direction DR1. For example, the second nanosheet separation layer NS2 may be spaced apart from an upper surface of the uppermost nanosheet of the second plurality of lower nanosheets BNW2 in the vertical direction DR3. Each of the first and second nanosheet separation layers NS1 and NS2 may include an insulating material. For example, each of the first and second nanosheet separation layers NS1 and NS2 may include at least one of silicon nitride (SiN), silicon oxycarbonitride (SiOCN), silicon boron carbonitride (SiBCN), silicon carbonitride (SiCN), silicon oxynitride (SiON) or their combination, but of the present disclosure are not limited thereto.

The first plurality of upper nanosheets UNW1 may be disposed on an upper surface of the first nanosheet separation layer NS1. The first plurality of upper nanosheets UNW1 may include a plurality of nanosheets stacked to be spaced apart from each other in the vertical direction DR3 on the upper surface of the first nanosheet separation layer NS1. For example, a lower surface of the lowermost nanosheet of the first plurality of upper nanosheets UNW1 may be spaced apart from the upper surface of the first nanosheet separation layer NS1 in the vertical direction DR3. The second plurality of upper nanosheets UNW2 may be disposed on an upper surface of the second nanosheet separation layer NS2. The second plurality of upper nanosheets UNW2 may be spaced apart from the first plurality of upper nanosheets UNW1 in the first horizontal direction DR1. The second plurality of upper nanosheets UNW2 may include a plurality of nanosheets stacked to be spaced apart from each other in the vertical direction DR3 on the upper surface of the second nanosheet separation layer NS2. For example, a lower surface of the lowermost nanosheets of the second plurality of upper nanosheets UNW2 may be spaced apart from the upper surface of the second nanosheet separation layer NS2 in the vertical direction DR3.

Although FIG. 2 and FIG. 3 illustrate that each of the first and second plurality of upper nanosheets UNW1 and UNW2 includes two nanosheets stacked in the vertical direction DR3, of the present disclosure are not limited thereto. In some implementations, each of the first and second plurality of upper nanosheets UNW1 and UNW2 may include three or more nanosheets stacked in the vertical direction DR3. For example, each of the first and second plurality of upper nanosheets UNW1 and UNW2 may include silicon (Si), but of the present disclosure are not limited thereto. In some implementations, each of the first and second plurality of upper nanosheets UNW1 and UNW2 may include silicon germanium (SiGe).

For example, sidewalls of each of the first plurality of lower nanosheets BNW1, the first nanosheet separation layer NS1 and the first plurality of upper nanosheets UNW1 in the first horizontal direction DR1 may be aligned. In addition, sidewalls of each of the first plurality of lower nanosheets BNW1, the first nanosheet separation layer NS1 and the first plurality of upper nanosheets UNW1 in the second horizontal direction DR2 may be aligned. However, of the present disclosure are not limited to these examples. For example, sidewalls of each of the second plurality of lower nanosheets BNW2, the second nanosheet separation layer NS2 and the second plurality of upper nanosheets UNW2 in the first horizontal direction DR1 may be aligned. In addition, sidewalls of each of the second plurality of lower nanosheets BNW2, the second nanosheet separation layer NS2 and the second plurality of upper nanosheets UNW2 in the second horizontal direction DR2 may be aligned. However, of the present disclosure are not limited to these examples.

The first gate electrode G1 may extend in the second horizontal direction DR2 on the field insulating layer 105 and the insulating pattern 101. For example, the first gate electrode G1 may surround each of the first plurality of lower nanosheets BNW1, the first nanosheet separation layer NS1 and the first plurality of upper nanosheets UNW1, but of the present disclosure are not limited thereto. In some implementations, the first gate electrode G1 may include a first lower gate electrode and a first upper gate electrode, which are spaced apart from each other in the vertical direction DR3. In this case, the first lower gate electrode may surround the first plurality of lower nanosheets BNW1 and a portion of the first nanosheet separation layer NS1, and the first upper gate electrode may surround another portion of the first nanosheet separation layer NS1 and the first plurality of upper nanosheets UNW1.

The second gate electrode G2 may extend in the second horizontal direction DR2 on the field insulating layer 105 and the insulating pattern 101. The second gate electrode G2 may be spaced apart from the first gate electrode G1 in the first horizontal direction DR1. For example, the second gate electrode G2 may surround each of the second plurality of lower nanosheets BNW2, the second nanosheet separation layer NS2 and the second plurality of upper nanosheets UNW2, but of the present disclosure are not limited thereto. In some implementations, the second gate electrode G2 may include a second lower gate electrode and a second upper gate electrode, which are spaced apart from each other in the vertical direction DR3. In this case, the second lower gate electrode may surround the second plurality of lower nanosheets BNW2 and a portion of the second nanosheet separation layer NS2, and the second upper gate electrode may surround another portion of the second nanosheet separation layer NS2 and the second plurality of upper nanosheets UNW2.

For example, each of the first and second gate electrodes G1 and G2 may include at least one of titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAIN), tantalum aluminum nitride (TaAIN), tungsten nitride (WN), ruthenium (Ru), titanium aluminum (TiAl), titanium aluminum carbonitride (TiAIC-N), titanium aluminum carbide (TiAIC), titanium carbide (TiC), tantalum carbonitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), or their combination. Each of the first and second gate electrodes G1 and G2 may include a conductive metal oxide, a conductive metal oxynitride, or the like, and may include an oxidized form of the materials described above.

The first gate spacer 111 may extend in the second horizontal direction DR2 along respective sidewalls of the first gate electrode G1 on the upper surface of the uppermost nanosheet of the first plurality of upper nanosheets UNW1 and the upper surface of the field insulating layer 105. The second gate spacer 112 may extend in the second horizontal direction DR2 along respective sidewalls of the second gate electrode G2 on the upper surface of the uppermost nanosheet of the second plurality of upper nanosheets UNW2 and the upper surface of the field insulating layer 105. For example, each of the first and second gate spacers 111 and 112 may include at least one of silicon nitride (SiN), silicon oxynitride (SiON), silicon oxide (SiO₂), silicon oxycarbonitride (SiOCN), silicon boron nitride (SiBN), silicon oxyboron nitride (SiOBN), silicon oxycarbide (SiOC), or their combination, but of the present disclosure are not limited thereto.

The first gate insulating layer 121 may be disposed between the first gate electrode G1 and the field insulating layer 105. The first gate insulating layer 121 may be disposed between the first gate electrode G1 and the first gate spacer 111. The first gate insulating layer 121 may be disposed between the first gate electrode G1 and the first plurality of lower nanosheets BNW1. The first gate insulating layer 121 may be disposed between the first gate electrode G1 and the first nanosheet separation layer NS1. The first gate insulating layer 121 may be disposed between the first gate electrode G1 and the first plurality of upper nanosheets UNW1. The first gate insulating layer 121 may be disposed on the respective sidewalls of the first gate electrode G1 in the first horizontal direction DR1.

The second gate insulating layer 122 may be disposed between the second gate electrode G2 and the field insulating layer 105. The second gate insulating layer 122 may be disposed between the second gate electrode G2 and the second gate spacer 112. The second gate insulating layer 122 may be disposed between the second gate electrode G2 and the second plurality of lower nanosheets BNW2. The second gate insulating layer 122 may be disposed between the second gate electrode G2 and the second nanosheet separation layer NS2. The second gate insulating layer 122 may be disposed between the second gate electrode G2 and the second plurality of upper nanosheets UNW2. The second gate insulating layer 122 may be disposed on the respective sidewalls of the second gate electrode G2 in the first horizontal direction DR1.

Each of the first and second gate insulating layers 121 and 122 may include at least one of silicon oxide, silicon oxynitride, silicon nitride, or a high dielectric constant material having a dielectric constant greater than that of silicon oxide. For example, the high dielectric constant material may include at least one of hafnium oxide, hafnium silicon oxide, hafnium aluminum oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide or lead zinc niobate.

The semiconductor device according to some implementations may include a negative capacitance (NC) FET based on a negative capacitor. For example, each of the first and second gate insulating layers 121 and 122 may include a ferroelectric material film having ferroelectric characteristics and a paraelectric material film having paraelectric characteristics.

The ferroelectric material film may have a negative capacitance, and the paraelectric material film may have a positive capacitance. For example, when two or more capacitors are connected in series, and the capacitance of each capacitor has a positive value, the total capacitance is more reduced than the capacitance of each individual capacitor. On the other hand, when at least one of capacitances of two or more capacitors connected in series has a negative value, the total capacitance may have a positive value and may be greater than an absolute value of each individual capacitance.

When a ferroelectric material film having a negative capacitance and a paraelectric material film having a positive capacitance are connected in series, the total capacitance value of the ferroelectric material film and the paraelectric material film, which are connected in series, may be increased. Based on the total capacitance value that is increased, a transistor having a ferroelectric material film may have a subthreshold swing (SS) less than 60 mV/decade at a room temperature.

The ferroelectric material film may have ferroelectric characteristics. The ferroelectric material film may include at least one of, for example, hafnium oxide, hafnium zirconium oxide, barium strontium titanium oxide, barium titanium oxide, or lead zirconium titanium oxide. In this case, for example, the hafnium zirconium oxide may be a material doped with zirconium (Zr) in hafnium oxide. For another example, the hafnium zirconium oxide may be a compound of hafnium (Hf) and zirconium (Zr) and oxygen (O).

The ferroelectric material film may further include a doped dopant. For example, the dopant may include at least one of aluminum (Al), titanium (Ti), niobium (Nb), lanthanum (La), yttrium (Y), magnesium (Mg), silicon (Si), calcium (Ca), cerium (Ce), dysprosium (Dy), erbium (Er), gadolinium (Gd), germanium (Ge), scandium (Sc), strontium (Sr), or tin (Sn). A type of the dopant included in the ferroelectric material film may be varied depending on the ferroelectric material of the ferroelectric material film.

When the ferroelectric material film includes hafnium oxide, the dopant included in the ferroelectric material film may include at least one of gadolinium (Gd), silicon (Si), zirconium (Zr), aluminum (Al), or yttrium (Y).

When the dopant is aluminum (Al), the ferroelectric material film may include aluminum of 3 at% to 8 at% (atomic%). In this case, a ratio of the dopant may be a ratio of aluminum to a sum of hafnium and aluminum.

When the dopant is silicon (Si), the ferroelectric material film may include silicon of 2 at% to 10 at%. When the dopant is yttrium (Y), the ferroelectric material film may include yttrium of 2 at% to 10 at%. When the dopant is gadolinium (Gd), the ferroelectric material film may include gadolinium of 1 at% to 7 at%. When the dopant is zirconium (Zr), the ferroelectric material film may include zirconium of 50 at% to 80 at%.

The paraelectric material film may have paraelectric characteristics. The paraelectric material film may include at least one of, for example, silicon oxide or metal oxide having a high dielectric constant. The metal oxide included in the paraelectric material film may include, but is not limited to, at least one of hafnium oxide, zirconium oxide, or aluminum oxide.

The ferroelectric material film and the paraelectric material film may contain the same material. Although the ferroelectric material film has ferroelectric characteristics, the paraelectric material film may not have ferroelectric characteristics. For example, when the ferroelectric material film and the paraelectric material film include hafnium oxide, a crystal structure of hafnium oxide included in the ferroelectric material film is different from that of hafnium oxide included in the paraelectric material film.

The ferroelectric material film may have a thickness having ferroelectric characteristics. The thickness of the ferroelectric material film may be, for example, 0.5 nm to 10 nm, but is not limited thereto. Since a threshold thickness indicating ferroelectric characteristics may be varied depending on each ferroelectric material, the thickness of the ferroelectric material film may be varied depending on the ferroelectric material.

For example, each of the first and second gate insulating layers 121 and 122 may include one ferroelectric material film. For another example, each of the first and second gate insulating layers 121 and 122 may include a plurality of ferroelectric material films spaced apart from each other. Each of the first and second gate insulating layers 121 and 122 may have a stacked layer structure in which a plurality of ferroelectric material films and a plurality of paraelectric material films are alternately stacked.

The lower source/drain region BSD1 may be disposed on one side of the first gate electrode G1 on the insulating pattern 101. For example, the lower source/drain region BSD1 may be disposed between the first gate electrode G1 and the second gate electrode G2 on the insulating pattern 101. The lower source/drain region BSD1 may be disposed between the first plurality of lower nanosheets BNW1 and the second plurality of lower nanosheets BNW2 on the insulating pattern 101. For example, the lower source/drain region BSD1 may be in contact with the insulating pattern 101. For example, the lower source/drain region BSD1 may be in contact with the sidewalls of each of the first plurality of lower nanosheets BNW1 and the second plurality of lower nanosheets BNW2 in the first horizontal direction DR1. For example, an upper surface of the lower source/drain region BSD1 may be formed to be higher than each of the upper surface of the uppermost nanosheet of the first plurality of lower nanosheets BNW1 and the upper surface of the uppermost nanosheet of the second plurality of lower nanosheets BNW2. For example, the lower source/drain region BSD1 may be in contact with each of the first gate insulating layer 121 and the second gate insulating layer 122, but of the present disclosure are not limited thereto.

For example, the lower source/drain region BSD1 may be separated in the first horizontal direction DR1 by the source/drain contact CA1. For example, the lower source/drain region BSD1 may include a first portion BSD11 and a second portion BSD12, which are separated in the first horizontal direction DR1 by the source/drain contact CA1. That is, the second portion BSD12 of the lower source/drain region BSD1 may be spaced apart from the first portion BSD11 of the lower source/drain region BSD1 in the first horizontal direction DR1. For example, the first portion BSD11 of the lower source/drain region BSD1 may be disposed between the first plurality of lower nanosheets BNW1 and the source/drain contact CA1. For example, the second portion BSD12 of the lower source/drain region BSD1 may be disposed between the second plurality of lower nanosheets BNW2 and the source/drain contact CA1. The first portion BSD11 of the lower source/drain region BSD1 may be in contact with the sidewalls of the first plurality of lower nanosheets BNW1 in the first horizontal direction DR1. The second portion BSD12 of the lower source/drain region BSD1 may be in contact with the sidewalls of the second plurality of lower nanosheets BNW2 in the first horizontal direction DR1.

The upper source/drain region USD1 may be disposed on one side of the first gate electrode G1 on the lower source/drain region BSD1. For example, the upper source/drain region USD1 may be disposed between the first gate electrode G1 and the second gate electrode G2 on the lower source/drain region BSD1. The upper source/drain region USD1 may be disposed between the first plurality of lower nanosheets BNW1 and the second plurality of lower nanosheets BNW2 on the lower source/drain region BSD1. The upper source/drain region USD1 may be spaced apart from the lower source/drain region BSD1 in the vertical direction DR3. For example, the upper source/drain region USD1 may be in contact with the sidewalls of each of the first plurality of lower nanosheets BNW1 and the second plurality of lower nanosheets BNW2 in the first horizontal direction DR1. For example, a lower surface of the upper source/drain region USD1 may be formed to be lower than each of the lower surface of the lowermost nanosheet of the first plurality of upper nanosheets UNW1 and the lower surface of the lowermost nanosheet of the second plurality of upper nanosheets UNW2. For example, the upper surface of the upper source/drain region USD1 may be formed to be higher than each of the upper surface of the uppermost nanosheet of the first plurality of upper nanosheets UNW1 and the upper surface of the uppermost nanosheet of the second plurality of upper nanosheets UNW2.

The first etching stop layer 140 may be disposed on the upper surface of the field insulating layer 105, and the sidewalls and the upper surface of the lower source/drain region BSD1 in the second horizontal direction DR2. The first etching stop layer 140 may be disposed on the sidewall of each of the first and second nanosheet separation layers NS1 and NS2 in the first horizontal direction DR1. For example, the first etching stop layer 140 may be formed to be conformal. For example, the first etching stop layer 140 may be in contact with each of the field insulating layer 105, the lower source/drain region BSD1, and the first and second nanosheet separation layers NS1 and NS2. For example, the first etching stop layer 140 may be in contact with each of the first and second gate insulating layers 121 and 122. For example, the first etching stop layer 140 may include at least one of aluminum oxide, aluminum nitride, hafnium oxide, zirconium oxide, silicon oxide, silicon nitride, silicon oxynitride, or a low dielectric constant material.

The first upper interlayer insulating layer 145 may be disposed on the first etching stop layer 140. For example, the first upper interlayer insulating layer 145 may cover the lower source/drain region BSD1 on the upper surface of the field insulating layer 105. For example, the first upper interlayer insulating layer 145 may be disposed between the upper surface of the lower source/drain region BSD1 and the lower surface of the upper source/drain region USD1. For example, the first upper interlayer insulating layer 145 may be disposed between the first nanosheet separation layer NS1 and the second nanosheet separation layer NS2. For example, the first etching stop layer 140 may be disposed between the first upper interlayer insulating layer 145 and the sidewall of the first nanosheet separation layer NS1 in the first horizontal direction DR1. Also, the first etching stop layer 140 may be disposed between the first upper interlayer insulating layer 145 and the sidewall of the second nanosheet separation layer NS2 in the first horizontal direction DR1.

For example, the first upper interlayer insulating layer 145 may include at least one of silicon oxide, silicon nitride, silicon oxynitride, or a low dielectric constant material. The low dielectric constant material may include, for example, Fluorinated TetraEthylOrthoSilicate (FTEOS), Hydrogen SilsesQuioxane (HSQ), Bis-benzoCycloButene (BCB), TetraMethylOrthoSilicate (TMOS), OctaMethylCycloTetraSiloxane (OMCTS), HexaMethylDiSiloxane (HMDS), TriMethylSilyl Borate (TMSB), DiAcetoxyDitertiaryButoxySiloxane (DADBS), TriMethylSilyl Phosphate (TMSP), PolyTetraFluoroEthylene (PTFE), Tonen SilaZen (TOSZ), Fluoride Silicate Glass (FSG), polyimide nanofoams such as polypropylene oxide, Carbon Doped silicon Oxide (CDO), Organo Silicate Glass (OSG), SiLK, Amorphous Fluorinated Carbon, silica aerogels, silica xerogels, mesoporous silica or their combination, but of the present disclosure are not limited thereto.

The second etching stop layer 150 may be disposed on an upper surface of the first upper interlayer insulating layer 145, the lower surface and the upper surface of the upper source/drain region USD1, and the sidewall of each of the first and second gate spacers 111 and 112 in the second horizontal direction DR2. For example, the second etching stop layer 150 may be formed to be conformal. For example, the second etching stop layer 150 may be in contact with each of the first upper interlayer insulating layer 145, the upper source/drain region USD1, and the first and second gate spacers 111 and 112. For example, the second etching stop layer 150 may include at least one of aluminum oxide, aluminum nitride, hafnium oxide, zirconium oxide, silicon oxide, silicon nitride, silicon oxynitride, or a low dielectric constant material.

The first capping pattern 131 may extend in the second horizontal direction DR2 on each of the first gate spacer 111, the first gate insulating layer 121 and the first gate electrode G1. The second capping pattern 132 may extend in the second horizontal direction DR2 on each of the second gate spacer 112, the second gate insulating layer 122 and the second gate electrode G2. For example, a lower surface of each of the first and second capping patterns 131 and 132 may be in contact with the second etching stop layer 150, but of the present disclosure are not limited thereto. In some implementations, a sidewall of each of the first and second capping patterns 131 and 132 may be in contact with the second etching stop layer 150. For example, each of the first and second capping patterns 131 and 132 may include at least one of silicon nitride (SiN), silicon oxynitride (SiON), silicon oxide (SiO₂), silicon carbonitride (SiCN), silicon oxycarbonitride (SiOCN), or their combination, but of the present disclosure are not limited thereto.

The second upper interlayer insulating layer 155 may be disposed on the second etching stop layer 150. For example, the second upper interlayer insulating layer 155 may be in contact with the second etching stop layer 150. The second upper interlayer insulating layer 155 may be disposed on the sidewall of each of the first and second capping patterns 131 and 132. The second upper interlayer insulating layer 155 may cover the upper source/drain region USD1. That is, the second upper interlayer insulating layer 155 may be disposed on the upper surface of the upper source/drain region USD1. For example, an upper surface of the second upper interlayer insulating layer 155 may be formed on the same plane as the upper surface of each of the first and second capping patterns 131 and 132. For example, the second upper interlayer insulating layer 155 may include at least one of silicon oxide, silicon nitride, silicon oxynitride, or a low dielectric constant material.

The first gate contact CB1 may be connected to the first gate electrode G1 by passing through the first capping pattern 131 in the vertical direction DR3. The first gate contact CB1 may be electrically connected to the first gate electrode G1. The second gate contact CB2 may be connected to the second gate electrode G2 by passing through the second capping pattern 132 in the vertical direction DR3. The second gate contact CB2 may be electrically connected to the second gate electrode G2. For example, an upper surface of each of the first and second gate contacts CB1 and CB2 may be formed on the same plane as the upper surface of the second upper interlayer insulating layer 155. Each of the first and second gate contacts CB1 and CB2 may include a conductive material.

The source/drain contact CA1 may be disposed on one side of the first gate electrode G1. For example, the source/drain contact CA1 may be disposed between the first gate electrode G1 and the second gate electrode G2. For example, the source/drain contact CA1 may extend in the second horizontal direction DR2. For example, the source/drain contact CA1 may extend into the upper source/drain region USD1 by passing through the lower interlayer insulating layer 100, the insulating pattern 101, the lower source/drain region BSD1, the first etching stop layer 140, the second etching stop layer 150, and the first upper interlayer insulating layer 145 in the vertical direction DR3. That is, at least a portion of the source/drain contact CA1 may be disposed inside the upper source/drain region USD1. The source/drain contact CA1 may be electrically connected to each of the lower source/drain region BSD1 and the upper source/drain region USD1.

For example, a lower surface of the source/drain contact CA1 may be formed on the same plane as a lower surface of the lower interlayer insulating layer 100. For example, an upper surface of the source/drain contact CA1 may be formed between the lower surface of the upper source/drain region USD1 and the upper surface of the upper source/drain region USD1. For example, the source/drain contact CA1 may separate the lower source/drain region BSD1 in the first horizontal direction DR1. For example, respective sidewalls of the source/drain contact CA1 in the first horizontal direction DR1 may be spaced apart from each of the first and second nanosheet separation layers NS1 and NS2 in the first horizontal direction DR1. For example, the respective sidewalls of the source/drain contact CA1 in the first horizontal direction DR1 may be in contact with the first upper interlayer insulating layer 145. Also, respective sidewalls of the source/drain contact CA1 in the second horizontal direction DR2 may be in contact with the first upper interlayer insulating layer 145. For example, the respective sidewalls of the source/drain contact CA1 in the first horizontal direction DR1 may be in contact with the lower interlayer insulating layer 100 and the insulating pattern 101, respectively. Also, the respective sidewalls of the source/drain contact CA1 in the second horizontal direction DR2 may be in contact with the lower interlayer insulating layer 100 and the insulating pattern 101, respectively.

For example, a width of the source/drain contact CA1 in the second horizontal direction DR2 may be greater than a width of the insulating pattern 101 in the second horizontal direction DR2. For example, a width of the lower surface of the source/drain contact CA1 in the first horizontal direction DR1 is greater than a width of the upper surface of the source/drain contact CA1 in the first horizontal direction DR1. Also, a width of the lower surface of the source/drain contact CA1 in the second horizontal direction DR2 is greater than a width of the upper surface of the source/drain contact CA1 in the second horizontal direction DR2. For example, the source/drain contact CA1 may be formed as a single layer, but of the present disclosure are not limited thereto. In some implementations, the source/drain contact CA1 may be formed as a multi-layer. The source/drain contact CA1 may include a conductive material.

The lower silicide layer BSL may be disposed along a boundary surface between the lower source/drain region BSD1 and the source/drain contact CA1. For example, the lower silicide layer BSL may extend from the lower surface of the lower source/drain region BSD1 to the upper surface of the lower source/drain region BSD1 along respective sidewalls of the lower source/drain region BSD1 in the first horizontal direction DR1. The upper silicide layer USL may be disposed along a boundary surface between the upper source/drain region USD1 and the source/drain contact CA1. Each of the lower silicide layer BSL and the upper silicide layer USL may include a metal silicide material.

The third etching stop layer 160 may be disposed on the upper surface of each of the first and second capping patterns 131 and 132, the first and second gate contacts CB1 and CB2, and the second upper interlayer insulating layer 155. Although FIG. 2 to FIG. 4 illustrate that the third etching stop layer 160 is formed as a single film, of the present disclosure are not limited thereto. In some implementations, the third etching stop layer 160 may be formed of a multi-film. For example, the third etching stop layer 160 may include at least one of aluminum oxide, aluminum nitride, hafnium oxide, zirconium oxide, silicon oxide, silicon nitride, silicon oxynitride, or a low dielectric constant material.

The third upper interlayer insulating layer 165 may be disposed on the third etching stop layer 160. For example, the third upper interlayer insulating layer 165 may include at least one of silicon oxide, silicon nitride, silicon oxynitride, or a low dielectric constant material. The first via V1 may be connected to the first gate contact CB1 by passing through the third upper interlayer insulating layer 165 and the third etching stop layer 160 in the vertical direction DR3. The second via V2 may be connected to the second gate contact CB2 by passing through the third upper interlayer insulating layer 165 and the third etching stop layer 160 in the vertical direction DR3. Each of the first via V1 and the second via V2 may include a conductive material.

For example, the first and second gate electrodes G1 and G2, the lower source/drain region BSD1, and the first and second plurality of lower nanosheets BNW1 and BNW2 may form a PMOS transistor. The first and second gate electrodes G1 and G2, the upper source/drain region USD1, and the first and second plurality of upper nanosheets UNW1 and UNW2 may form an NMOS transistor. That is, the semiconductor device may have a structure in which an NMOS transistor is stacked on a PMOS transistor in the vertical direction DR3, but of the present disclosure are not limited thereto.

In some implementations, the first and second gate electrodes G1 and G2, the lower source/drain region BSD1, and the first and second plurality of lower nanosheets BNW1 and BNW2 may form an NMOS transistor. The first and second gate electrodes G1 and G2, the upper source/drain region USD1, and the first and second plurality of upper nanosheets UNW1 and UNW2 may form a PMOS transistor. That is, the semiconductor device according to some implementations of the present disclosure may have a structure in which a PMOS transistor is stacked on an NMOS transistor in the vertical direction DR3.

For example, the distribution of the source/drain region of the PMOS transistor may be more uniform than that of the source/drain region of the NMOS transistor. For example, in the semiconductor device, the PMOS transistor may be formed on a lower portion, and the NMOS transistor may be formed on an upper portion. That is, the distribution of the lower source/drain region BSD1 of the PMOS transistor may be more uniform than that of the upper source/drain region USD1 of the NMOS transistor. In the semiconductor device, the source/drain contact CA1 may extend into the upper source/drain region USD1 by passing through the lower source/drain region BSD1, which is relatively uniformly distributed, in the vertical direction DR3. As a result, the semiconductor device may improve reliability in connection between the source/drain contact CA1 and the lower source/drain region BSD1.

For example, when the source/drain contact CA1 is connected to the lower source/drain region BSD1 by passing through the second upper interlayer insulating layer 155 and the upper source/drain region USD1, which are disposed between the first gate electrode G1 and the second gate electrode G2, in the vertical direction DR3, the source/drain contact CA1 may have a short with each of the first and second gate electrodes G1 and G2. In the semiconductor device, the source/drain contact CA1 may be connected to the upper source/drain region USD1 by passing through the lower source/drain region BSD1 in the vertical direction DR3. As a result, in the semiconductor device, the occurrence of the short between the source/drain contact CA1 and each of the first and second gate electrodes G1 and G2 may be reduced.

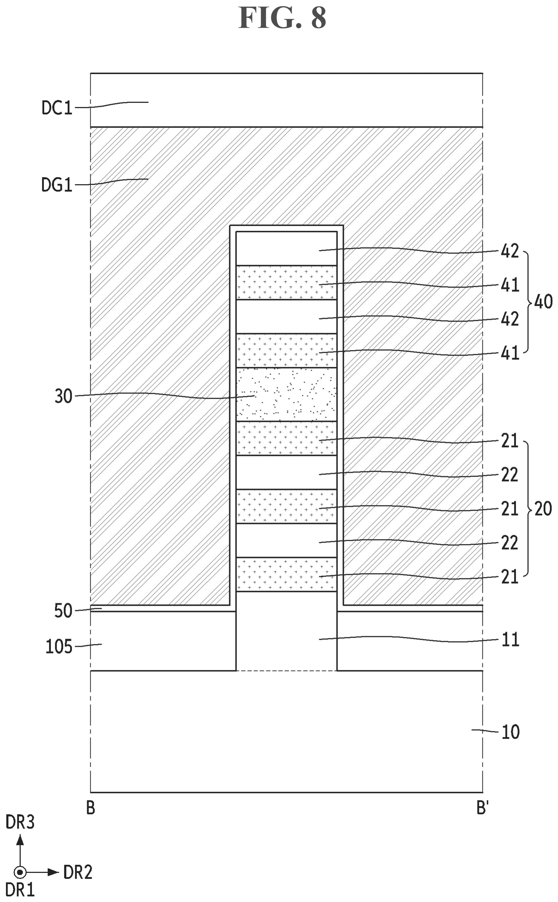

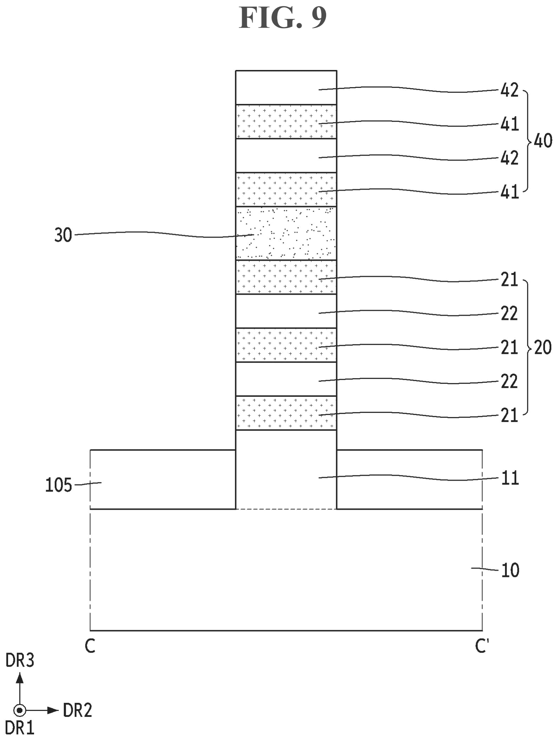

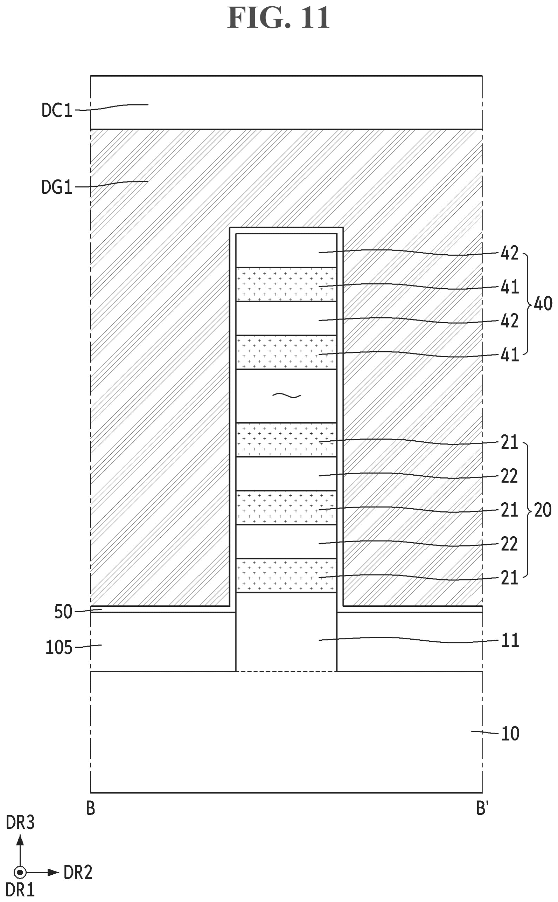

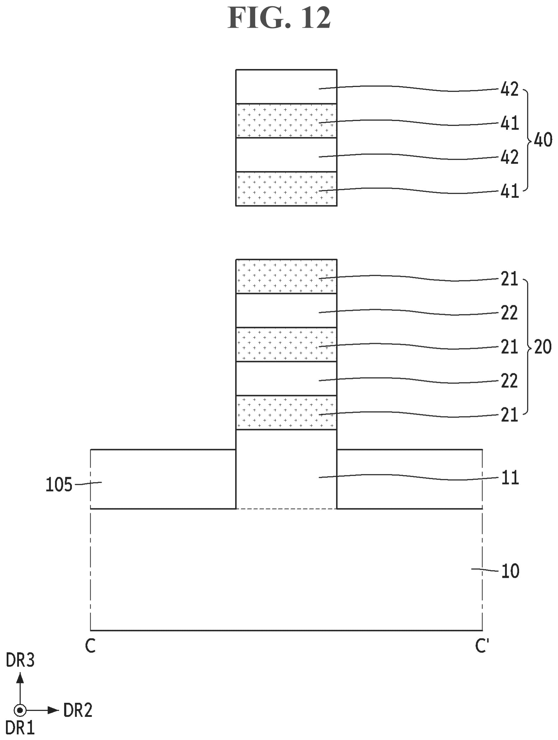

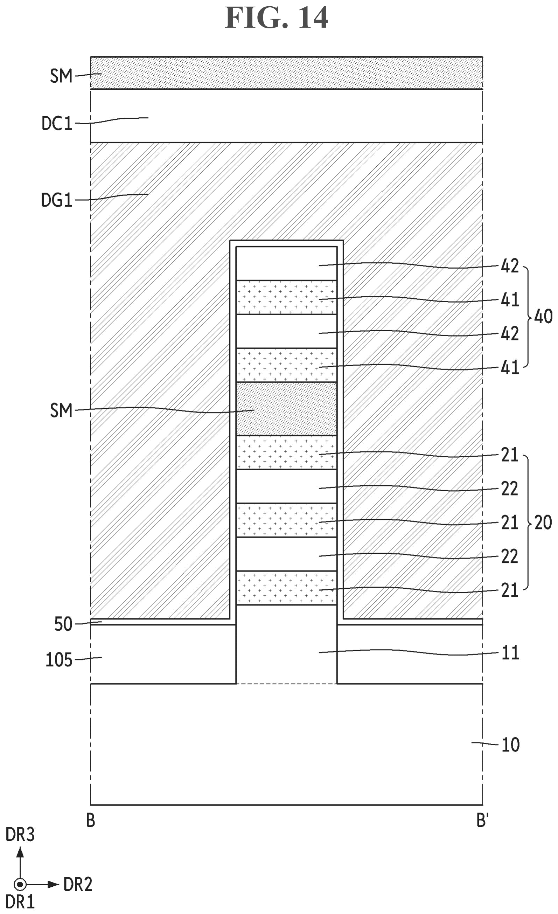

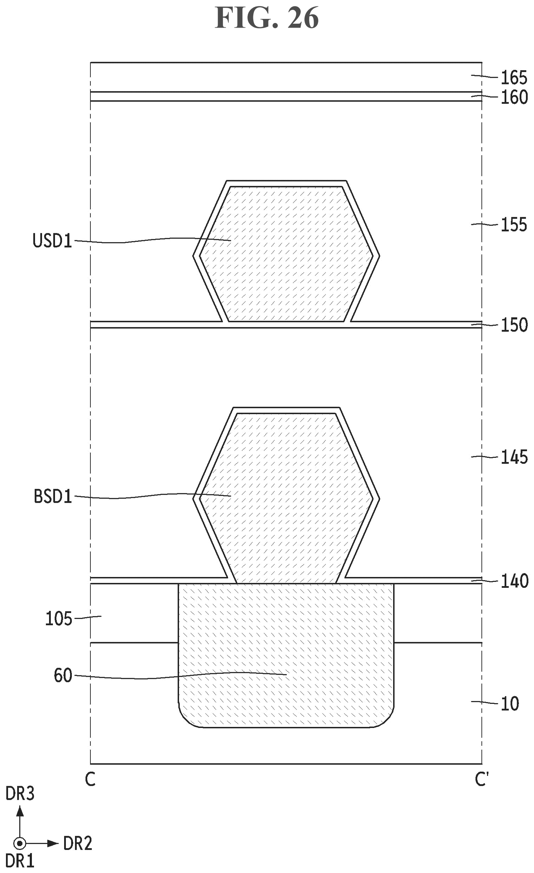

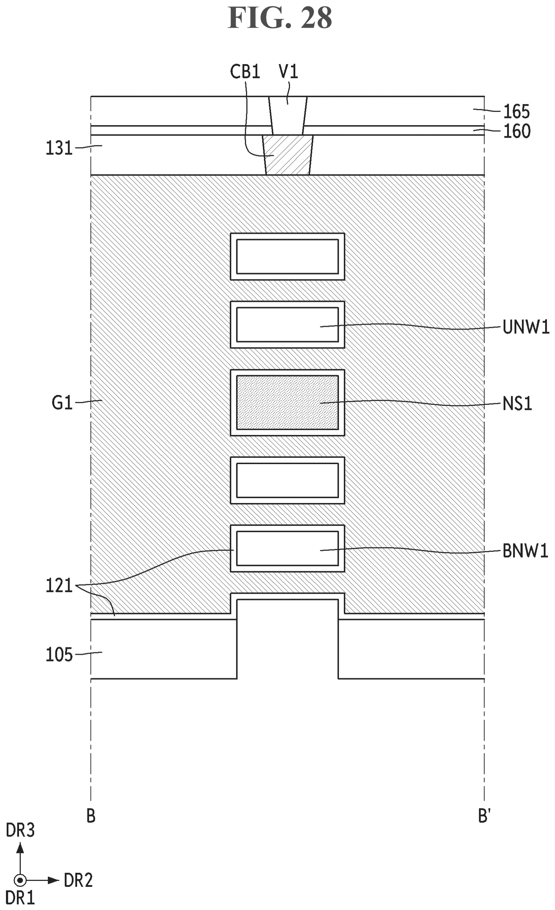

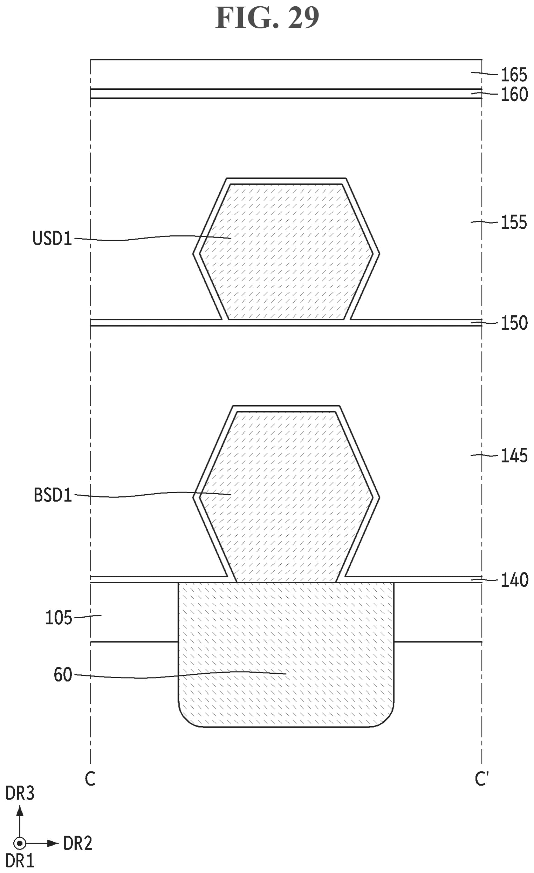

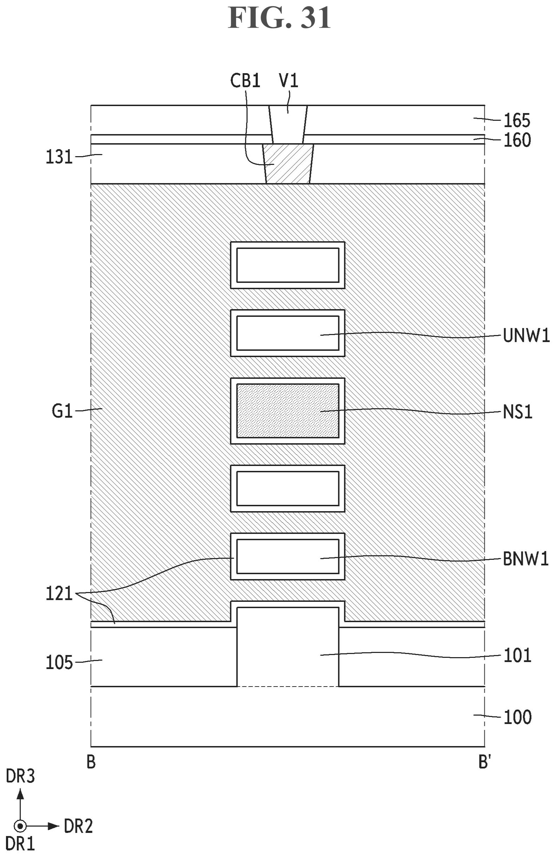

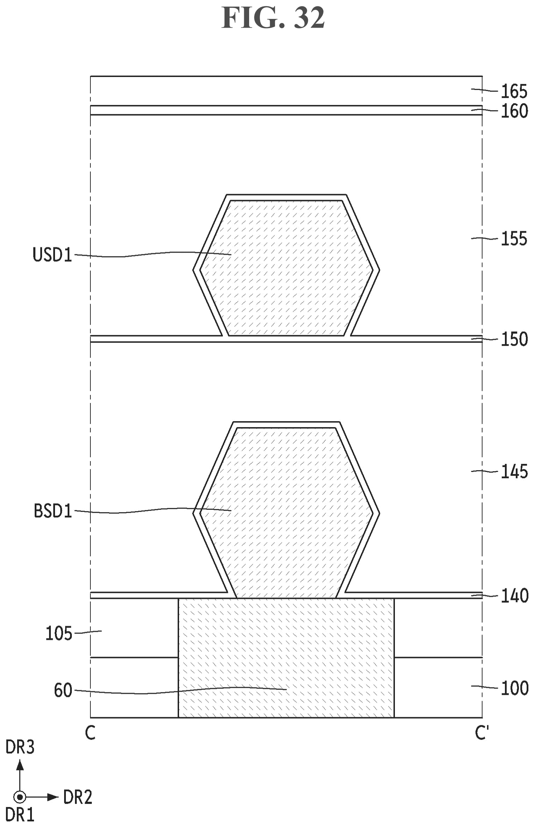

Hereinafter, a method for fabricating a semiconductor device will be described with reference to FIGS. 2 to 34.

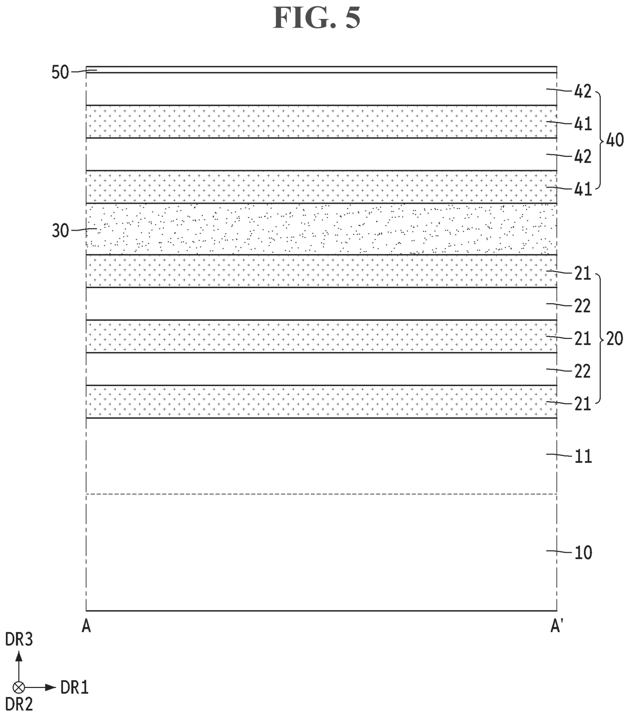

FIGS. 5, 6, 7, 8, 9, 10, 11, 12, 13, 14, 15, 16, 17, 18, 19, 20, 21, 22, 23, 24, 25, 26, 27, 28, 29, 30, 31, 32, 33, and 34 are views illustrating intermediate steps to describe an example of a method for fabricating a semiconductor device.

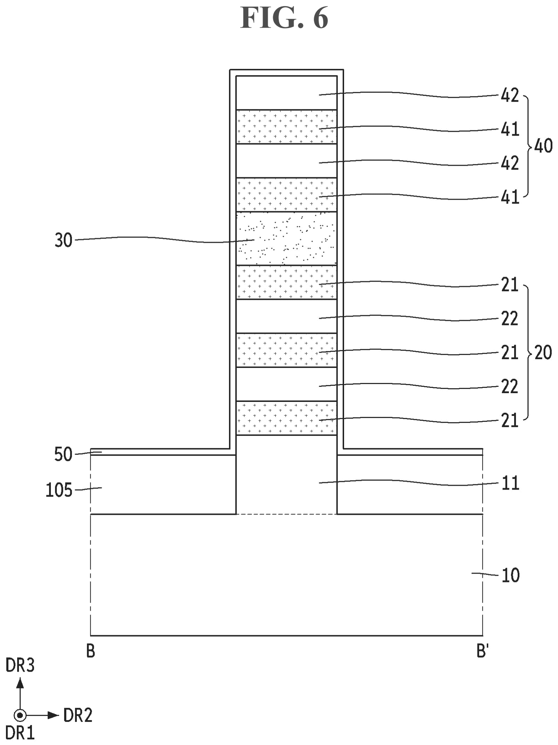

Referring to FIGS. 5 and 6, a first stacked structure 20, a separation material layer 30, and a second stacked structure 40 may be sequentially stacked on an upper surface of a substrate 10. The substrate 10 may be a silicon substrate or a silicon-on-insulator (SOI). Alternatively, the substrate 10 may include silicon germanium, silicon germanium on insulator (SGOI), indium antimonide, lead telluride, indium arsenide, indium phosphide, gallium arsenide or gallium antimonide, but is not limited thereto.

For example, the first stacked structure 20 may be formed on the upper surface of the substrate 10. The first stacked structure 20 may include a first semiconductor layer 21 and a second semiconductor layer 22, which are alternately stacked on the upper surface of the substrate 10. For example, a first semiconductor layer 21 may be formed on each of the lowermost and uppermost portions of the first stacked structure 20, but of the present disclosure are not limited thereto. In some implementations, the second semiconductor layer 22 may be formed on the uppermost portion of the first stacked structure 20. For example, the first semiconductor layer 21 may include silicon germanium (SiGe). For example, the second semiconductor layer 22 may include silicon (Si). Subsequently, the separation material layer 30 may be formed on an upper surface of the first stacked structure 20. The separation material layer 30 may include silicon germanium (SiGe).

Subsequently, the second stacked structure 40 may be formed on an upper surface of the separation material layer 30. The second stacked structure 40 may include a third semiconductor layer 41 and a fourth semiconductor layer 42, which are alternately stacked on the upper surface of the separation material layer 30. For example, the third semiconductor layer 41 may be formed on a lowermost portion of the second stacked structure 40, and the fourth semiconductor layer 42 may be formed on an uppermost portion of the second stacked structure 40. For example, the third semiconductor layer 41 may include silicon germanium (SiGe). For example, the fourth semiconductor layer 42 may include silicon (Si). For example, a concentration of germanium (Ge) included in the separation material layer 30 may be greater than a concentration of germanium (Ge) included in each of the first semiconductor layer 21 and the third semiconductor layer 41.

Then, a portion of each of the first stacked structure 20, the separation material layer 30, and the second stacked structure 40 may be etched. A portion of the substrate 10 may be etched while a portion of each of the first stacked structure 20, the separation material layer 30, and the second stacked structure 40 is etched. Through the etching process, an active pattern 11 may be defined below the first stacked structure 20. The active pattern 11 may protrude from the upper surface of the substrate 10 in the vertical direction DR3. The active pattern 11 may extend in the first horizontal direction DR1.

Subsequently, a field insulating layer 105 may be formed on the upper surface of the substrate 10. The field insulating layer 105 may surround sidewalls of the active pattern 11. For example, an upper surface of the active pattern 11 may be formed to be higher than an upper surface of the field insulating layer 105. Subsequently, a pad oxide layer 50 may be formed to cover the upper surface of the field insulating layer 105, exposed sidewalls of the active pattern 11, sidewalls of the first stacked structure 20, sidewalls of the separation material layer 30, and sidewalls and an upper surfaces of the second stacked structure 40. For example, the pad oxide layer 50 may be formed to be conformal. For example, the pad oxide layer 50 may include silicon oxide (SiO₂).

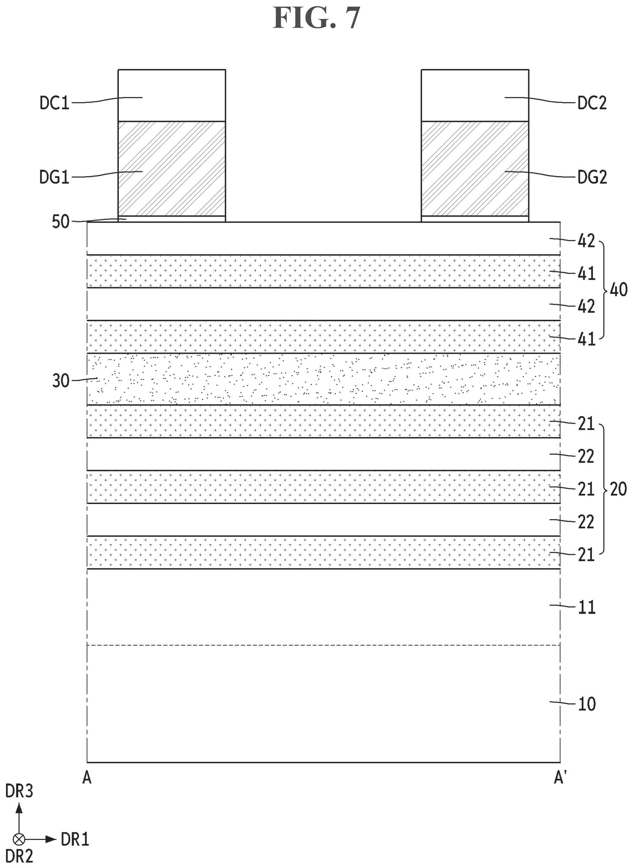

Referring to FIGS. 7 to 9, first and second dummy gates DG1 and DG2 and first and second dummy capping patterns DC1 and DC2, which extend in the second horizontal direction DR2, may be formed on the pad oxide layer 50 on the second stacked structure 40 and the field insulating layer 105. For example, the second dummy gate DG2 may be spaced apart from the first dummy gate DG1 in the first horizontal direction DR1. The first dummy capping pattern DC1 may be formed on the first dummy gate DG1. The second dummy capping pattern DC2 may be formed on the second dummy gate DG2. While the first and second dummy gates DG1 and DG2 and the first and second dummy capping patterns DC1 and DC2 are formed, the remaining pad oxide layer 50 except for a portion overlapping each of the first and second dummy gates DG1 and DG2 in the vertical direction DR3 on the substrate 10 may be etched.

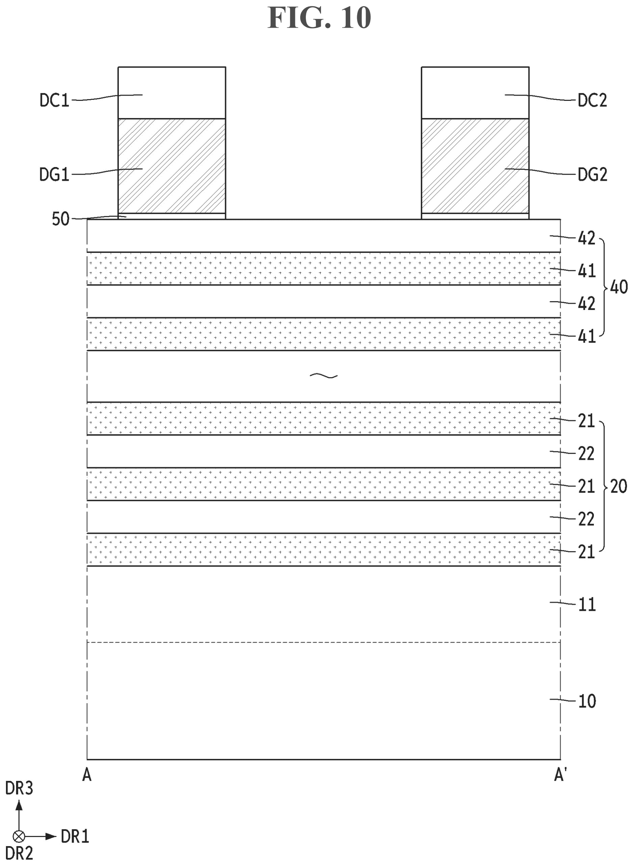

Referring to FIGS. 10 to 12, the separation material layer (30 of FIGS. 7 to 9) may be etched. For example, the separation material layer (30 of FIGS. 7 to 9) may be etched by a wet etching process.

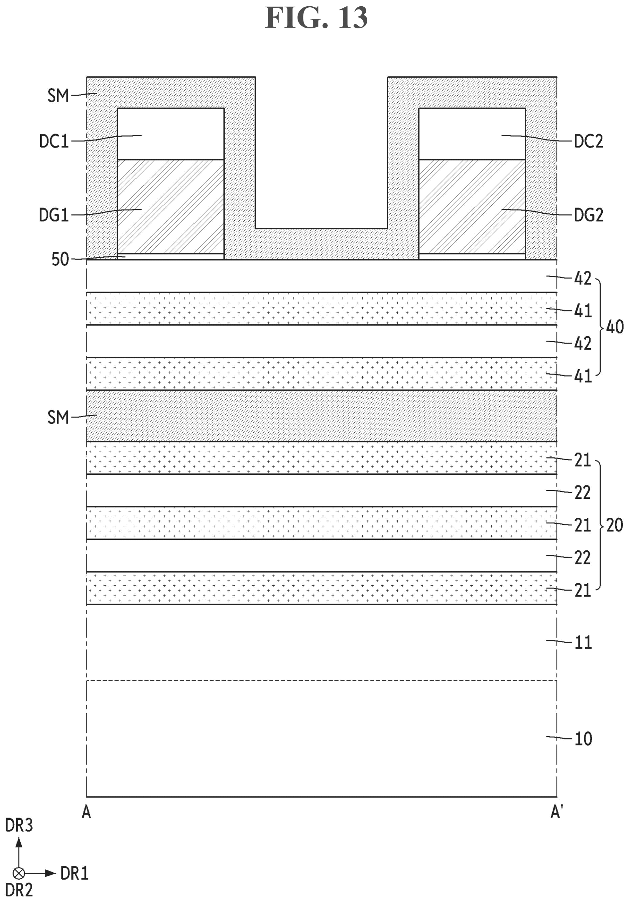

Referring to FIGS. 13 to 15, a spacer material layer SM may be formed to cover sidewalls of each of the first and second dummy gates DG1 and DG2, sidewalls and an upper surface of each of the first and second dummy capping patterns DC1 and DC2, the first stacked structure 20, the second stacked structure 40, and the upper surface of the field insulating layer 105. The spacer material layer SM may fill the etched portion of the separation material layer (30 of FIGS. 7 to 9). For example, the spacer material layer SM may be formed to be conformal. For example, the spacer material layer SM may include at least one of silicon nitride (SiN), silicon oxynitride (SiON), silicon carbonitride (SiCN), silicon oxycarbonitride (SiOCN), silicon boron nitride (SiBN), silicon oxyboron nitride (SiOBN), silicon oxycarbide (SiOC), or their combination.

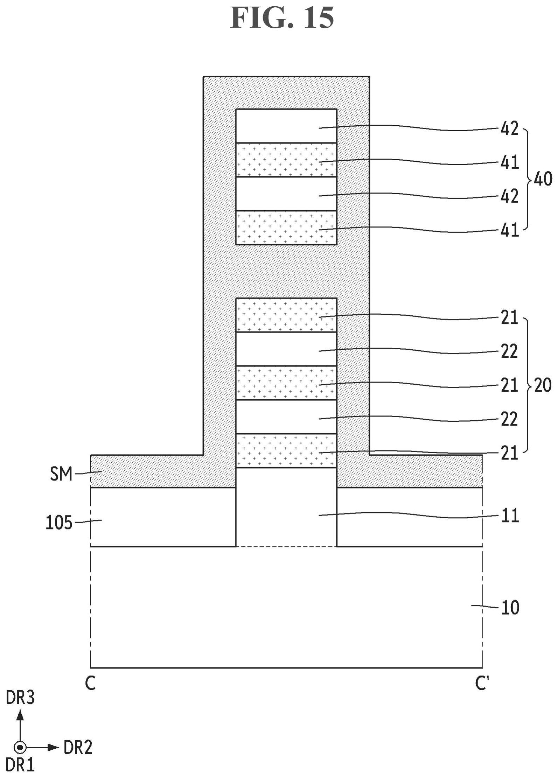

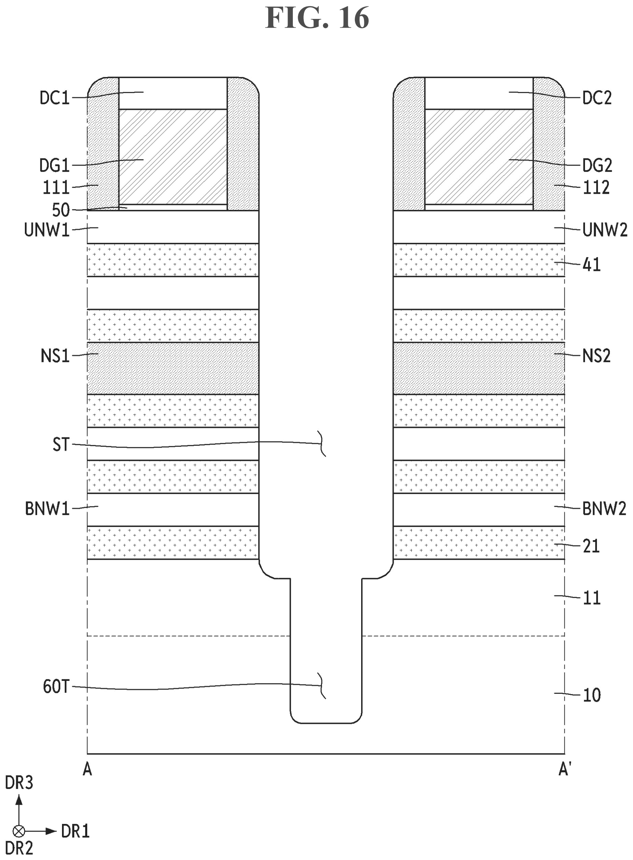

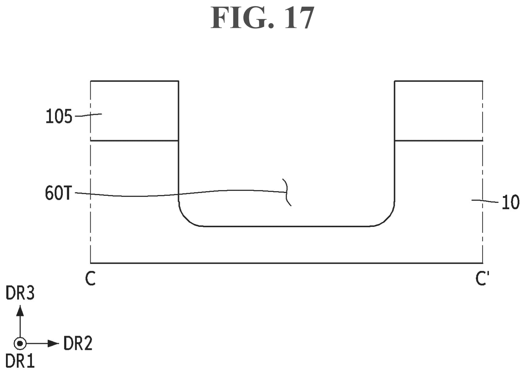

Referring to FIGS. 16 and 17, each of the first stacked structure (20 of FIGS. 13 and 15), the spacer material layer (SM of FIGS. 13 and 15), and the second stacked structure (40 of FIGS. 13 and 15) may be etched using the first and second dummy gates DG1 and DG2 and the first and second dummy capping patterns DC1 and DC2 as masks to form a source/drain trench ST. For example, the source/drain trench ST may extend into the active pattern 11. Subsequently, a sacrificial pattern trench 60T may be formed in a lower portion of the source/drain trench ST. For example, the sacrificial pattern trench 60T may be formed inside each of the active pattern 11 and the substrate 10. For example, a width of the sacrificial pattern trench 60T in the first horizontal direction DR1 may be less than a width of the source/drain trench ST in the first horizontal direction DR1, but of the present disclosure are not limited thereto.

For example, while the source/drain trench ST is formed, the spacer material layer (SM of FIG. 13) formed on the upper surface of each of the first and second dummy capping patterns DC1 and DC2 may be etched. For example, after the source/drain trench ST is formed, the spacer material layer (SM of FIG. 13) remaining on the sidewalls of each of the first and second dummy capping patterns DC1 and DC2 and the first and second dummy gates DG1 and DG2 may be defined as first and second gate spacers 111 and 112.

For example, after the source/drain trench ST is formed, the second semiconductor layer (22 of FIG. 13) and the fourth semiconductor layer (22 of FIG. 13), which remain below the first dummy gate DG1, may be defined as a first plurality of lower nanosheets BNW1 and a first plurality of upper nanosheets UNW1, respectively. Also, after the source/drain trench ST is formed, the second semiconductor layer (22 of FIG. 13) and the fourth semiconductor layer (42 of FIG. 13), which remain below the second dummy gate DG2, may be defined as a second plurality of lower nanosheets BNW2 and a second plurality of upper nanosheets UNW2, respectively. Furthermore, after the source/drain trench ST is formed, the spacer material layer (SM of FIG. 13) remaining below the first dummy gate DG1 may be defined as a first nanosheet separation layer NS1, and the spacer material layer (SM of FIG. 13) remaining below the second dummy gate DG2 may be defined as a second nanosheet separation layer NS2.

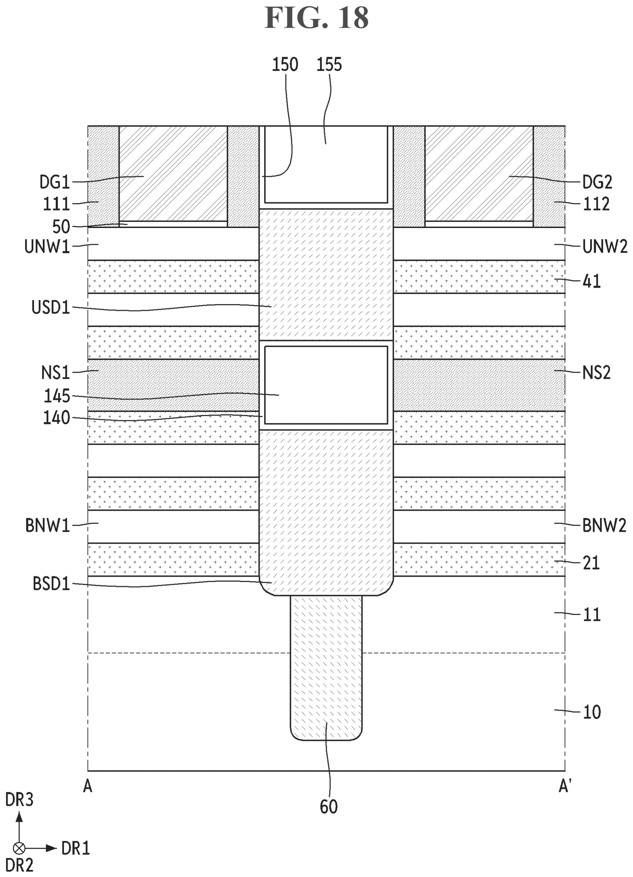

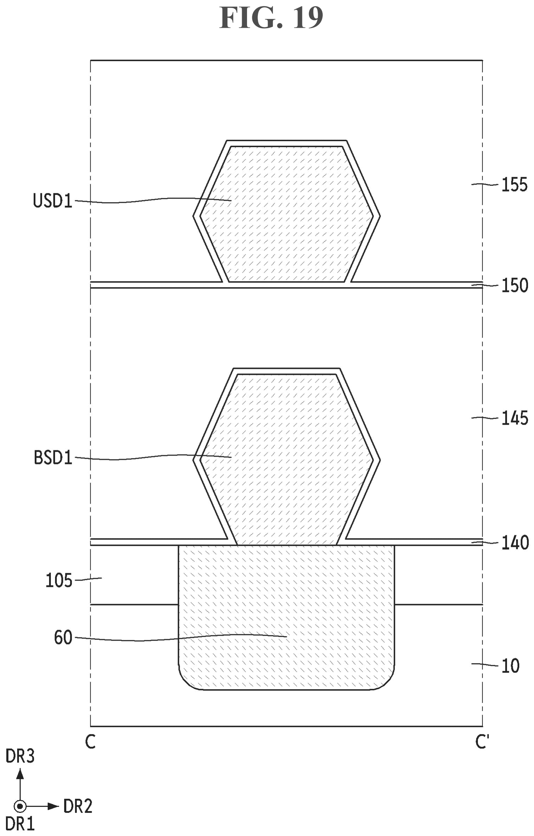

Referring to FIGS. 18 and 19, a sacrificial pattern 60 may be formed inside the sacrificial pattern trench (60T of FIGS. 16 and 17). Also, a lower source/drain region BSD1 may be formed inside the source/drain trench (ST of FIG. 16). The lower source/drain region BSD1 may be in contact with the active pattern 11. Also, the lower source/drain region BSD1 may be in contact with a sidewall of each of the first and second plurality of lower nanosheets BNW1 and BNW2 in the first horizontal direction DR1. Subsequently, a first etching stop layer 140 may be formed on the upper surface of the field insulating layer 105, sidewalls and an upper surface of the lower source/drain region BSD1 in the second horizontal direction DR2, and a sidewall of each of the first and second nanosheet separation layers NS1 and NS2 in the second horizontal direction DR2. For example, the first etching stop layer 140 may be formed to be conformal. Subsequently, a first upper interlayer insulating layer 145 may be formed on the first etching stop layer 140 to cover the lower source/drain region BSD1. For example, an upper surface of the first upper interlayer insulating layer 145 may be formed to be lower than a lower surface of the lowermost nanosheet of the first plurality of upper nanosheets UNW1.

Subsequently, an upper source/drain region USD1 may be formed on the upper surface of the first upper interlayer insulating layer 145 inside the source/drain trench (ST of FIG. 16). The upper source/drain region USD1 may be spaced apart from the lower source/drain region BSD1 in the vertical direction DR3. The upper source/drain region USD1 may be in contact with a sidewall of each of the first and second plurality of upper nanosheets UNW1 and UNW2 in the first horizontal direction DR1. Subsequently, a second etching stop layer 150 may be formed on the upper surface of the first upper interlayer insulating layer 145, an exposed surface of the upper source/drain region USD1, a sidewall of each of the first and second gate spacers 111 and 112, and an upper surface of each of the first and second dummy capping patterns DC1 and DC2. For example, the second etching stop layer 150 may be formed to be conformal. Subsequently, the upper surfaces of the first and second dummy gates DG1 and DG2 may be exposed by performing a planarization process.

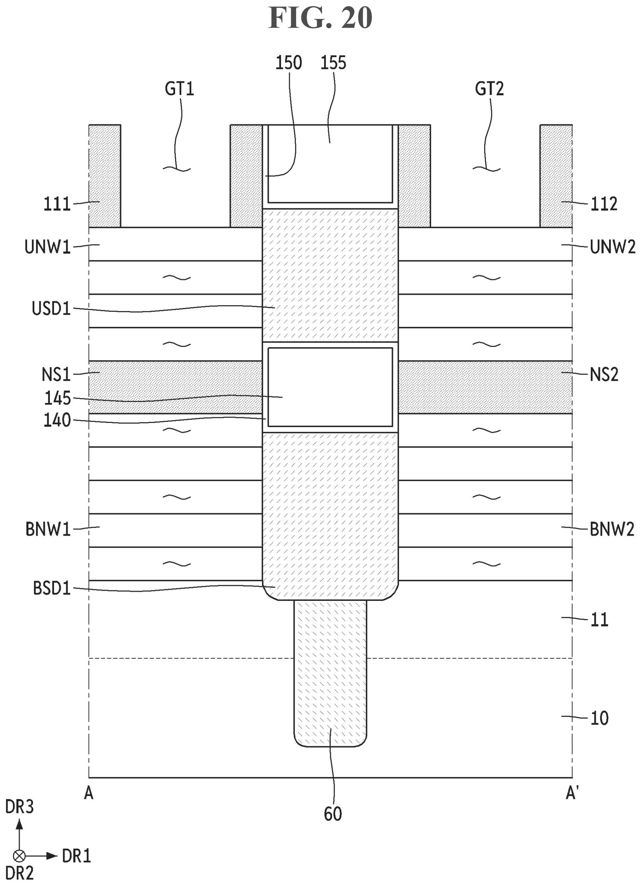

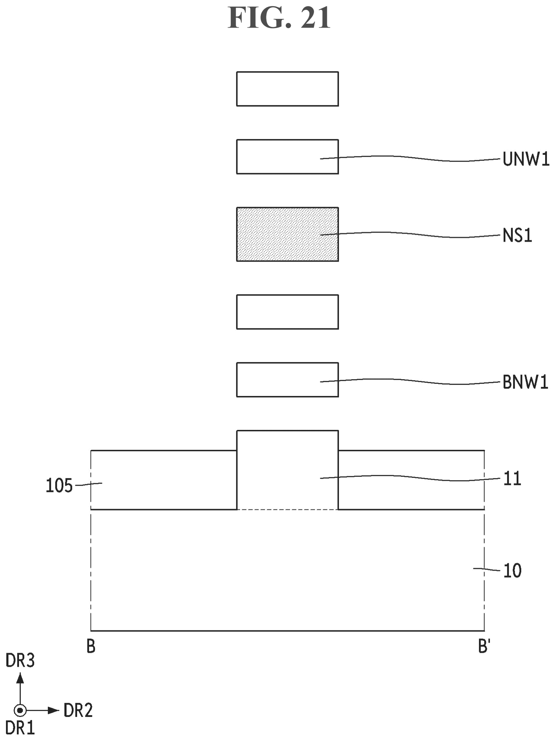

Referring to FIGS. 20 and 21, each of the first and second dummy gates (DG1 and DG2 of FIG. 18), the pad oxide layer (50 of FIG. 18), the first semiconductor layer (21 of FIG. 18), and the third semiconductor layer (41 of FIG. 18) may be etched. A portion in which each of the first dummy gate (DG1 of FIG. 18), the pad oxide layer (50 of FIG. 18), the first semiconductor layer (21 of FIG. 18), and the third semiconductor layer (41 of FIG. 18) is etched may be defined as a first gate trench GT1. Also, a portion in which each of the second dummy gate (DG2 of FIG. 18), the pad oxide layer (50 of FIG. 18), the first semiconductor layer (21 of FIG. 18), and the third semiconductor layer (41 of FIG. 18) is etched may be defined as a second gate trench GT2.

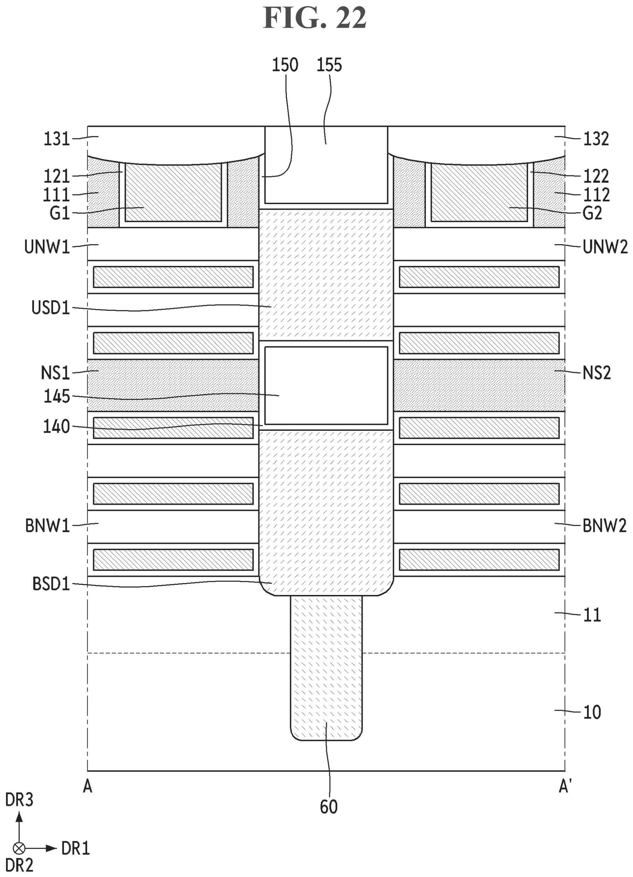

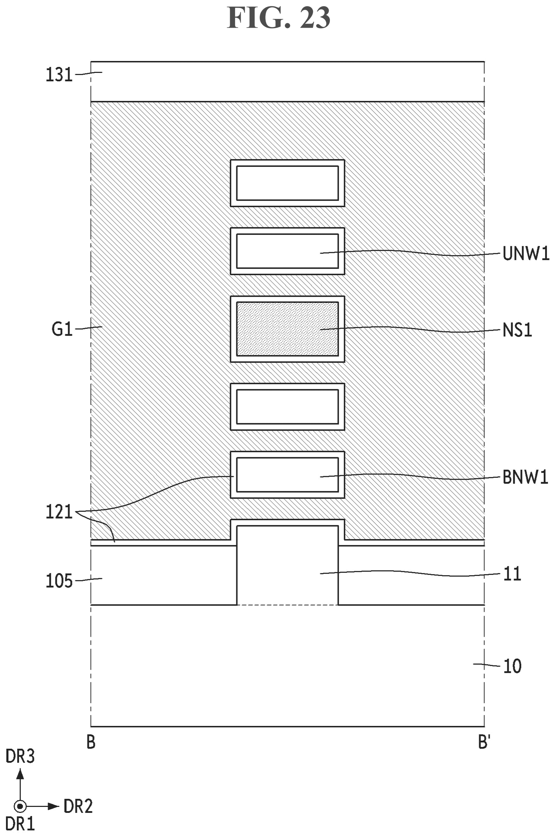

Referring to FIGS. 22 and 23, a first gate insulating layer 121, a first gate electrode G1 and a first capping pattern 131 may be sequentially formed inside the first gate trench (GT1 of FIG. 20). Also, a second gate insulating layer 122, a second gate electrode G2 and a second capping pattern 132 may be sequentially formed inside the second gate trench (GT2 of FIG. 20). For example, the first gate electrode G1 may surround each of the first plurality of lower nanosheets BNW1, the first nanosheet separation layer NS1 and the first plurality of upper nanosheets UNW1. The second gate electrode G2 may surround each of the second plurality of lower nanosheets BNW2, the second nanosheet separation layer NS2 and the second plurality of upper nanosheets UNW2.

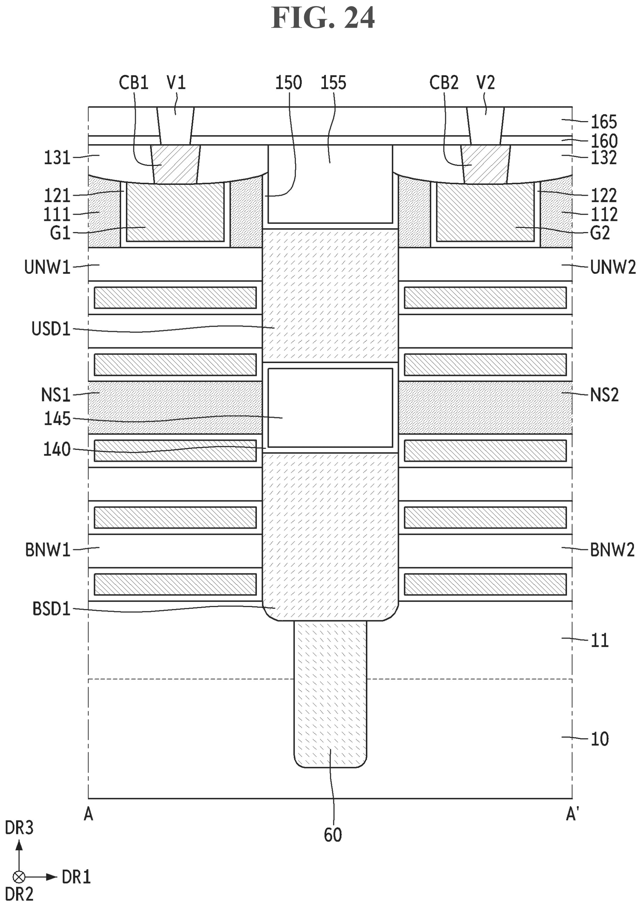

Referring to FIGS. 24 to 26, a first gate contact CB1 passing through the first capping pattern 131 in the vertical direction DR3 may be formed, and a second gate contact CB2 passing through the second capping pattern 132 in the vertical direction DR3 may be formed. Subsequently, a third etching stop layer 160 and a third upper interlayer insulating layer 165 may be sequentially formed on an upper surface of each of the first and second capping patterns 131 and 132, the second upper interlayer insulating layer 155 and the first and second gate contacts CB1 and CB2. Subsequently, a first via V1 connected to the first gate contact CB1 by passing through the third etching stop layer 160 and the third upper interlayer insulating layer 165 in the vertical direction DR3 may be formed, and a second via V2 connected to the second gate contact CB2 by passing through the third etching stop layer 160 and the third upper interlayer insulating layer 165 in the vertical direction DR3 may be formed.

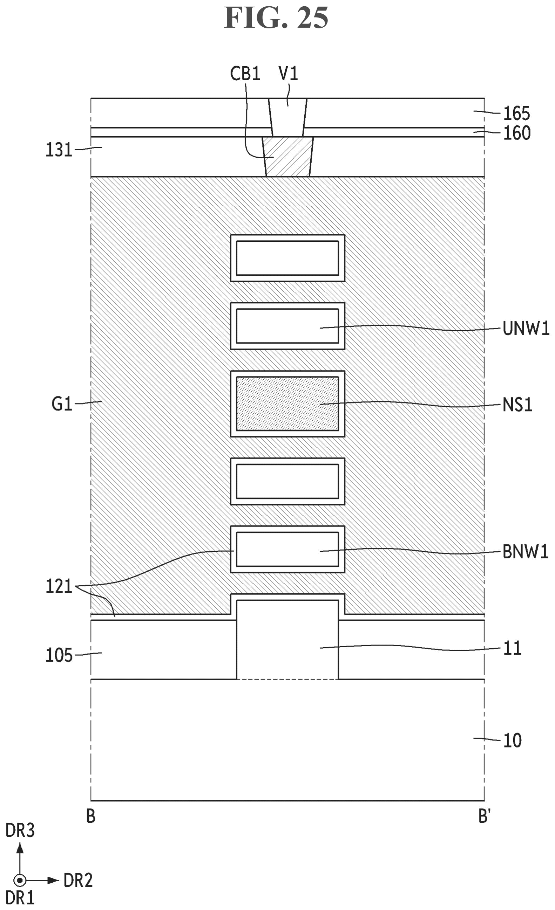

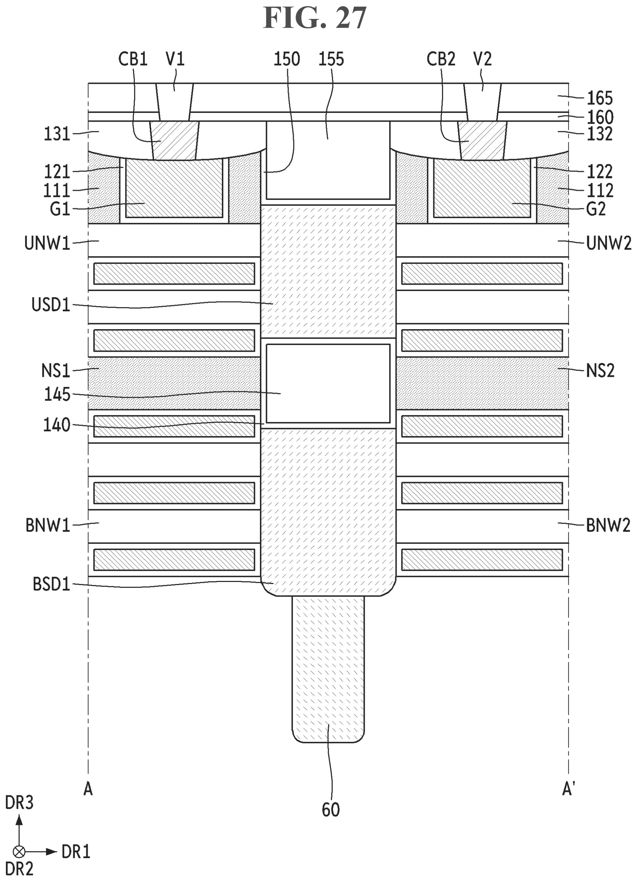

Referring to FIGS. 27 to 29, each of a substrate (10 of FIGS. 24 to 26) and an active pattern (11 of FIGS. 24 and 25) may be etched.

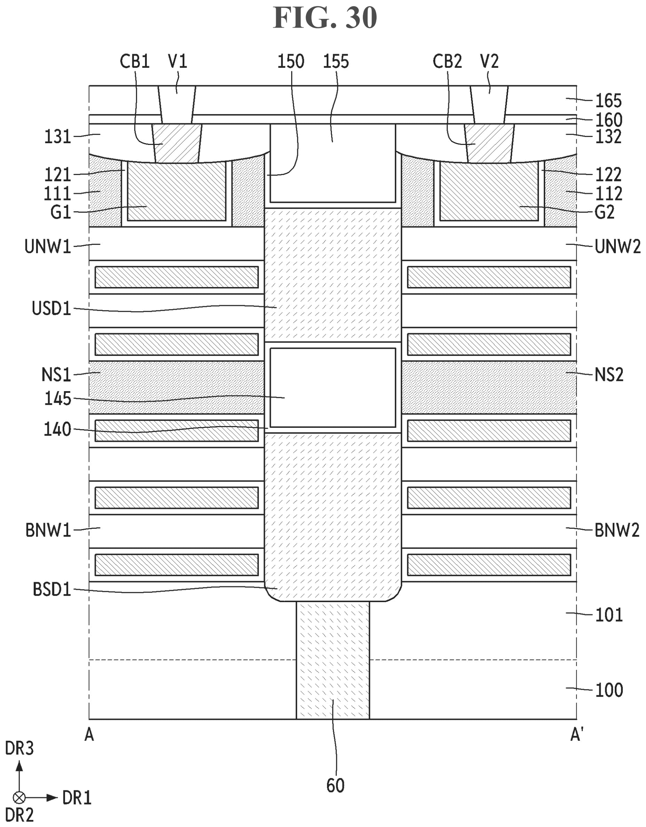

Referring to FIGS. 30 to 32, an insulating pattern 101 may be formed in a portion where the active pattern (11 of FIGS. 24 and 25) is etched, and a lower interlayer insulating layer 100 may be formed in a portion in which the substrate (10 of FIGS. 24 to 26) is etched. For example, the insulating pattern 101 may extend in the first horizontal direction DR1. Subsequently, a lower surface of the sacrificial pattern 60 may be exposed by performing a planarization process. For example, after performing the planarization process, the lower surface of the sacrificial pattern 60 may be formed on the same plane as a lower surface of the lower interlayer insulating layer 100.

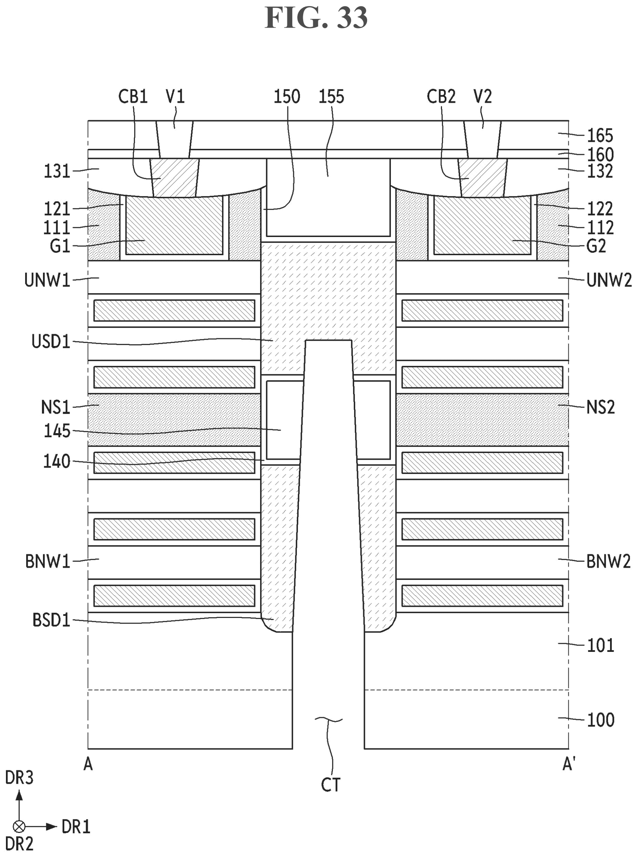

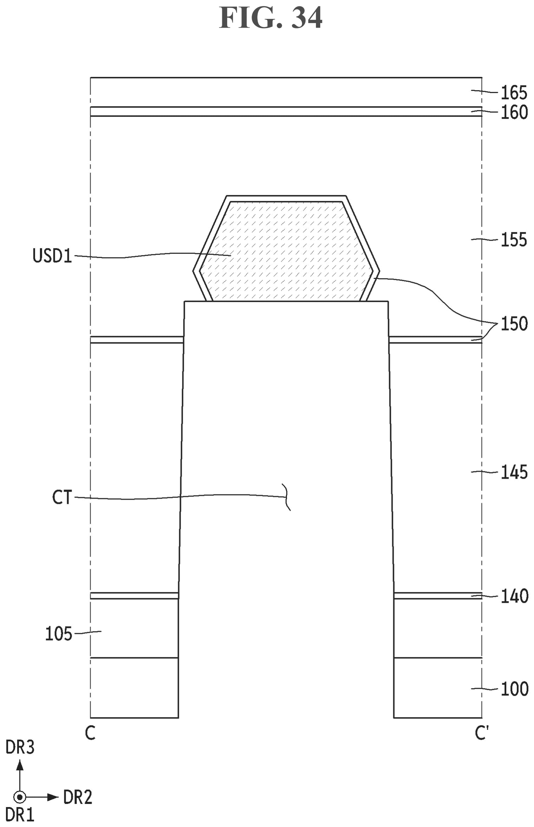

Referring to FIGS. 33 and 34, a contact trench CT may be formed between the first gate electrode G1 and the second gate electrode G2. For example, the contact trench CT may extend into the upper source/drain region USD1 by passing through the lower interlayer insulating layer 100, the insulating pattern 101, the lower source/drain region BSD1, the first etching stop layer 140, the first upper interlayer insulating layer 145, and the second etching stop layer 150 in the vertical direction DR3. For example, the upper source/drain region USD1 may be exposed through an upper surface of the contact trench CT. For example, a width of the lower surface of the contact trench CT in the first horizontal direction DR1 is greater than a width of an upper surface of the contact trench CT in the first horizontal direction DR1. Also, a width of the lower surface of the contact trench CT in the second horizontal direction DR2 is greater than a width of the upper surface of the contact trench CT in the second horizontal direction DR2.

Referring to FIGS. 2 to 4, a source/drain contact CA1 may be formed inside the contact trench (CT of FIGS. 33 and 34). That is, the source/drain contact CA1 may extend into the upper source/drain region USD1 by passing through the lower interlayer insulating layer 100, the insulating pattern 101, the lower source/drain region BSD1, the first etching stop layer 140, the second etching stop layer 150, and the first upper interlayer insulating layer 145 in the vertical direction DR3. The source/drain contact CA1 may be electrically connected to each of the lower source/drain region BSD1 and the upper source/drain region USD1.

For example, a lower surface of the source/drain contact CA1 may be formed on the same plane as the lower surface of the lower interlayer insulating layer 100. For example, a width of the lower surface of the source/drain contact CA1 in the first horizontal direction DR1 is greater than a width of an upper surface of the source/drain contact CA1 in the first horizontal direction DR1. Also, a width of the lower surface of the source/drain contact CA1 in the second horizontal direction DR2 is greater than a width of the upper surface of the source/drain contact CA1 in the second horizontal direction DR2. Also, a lower silicide layer BSL may be formed along a boundary surface between the lower source/drain region BSD1 and the source/drain contact CA1, and an upper silicide layer USL may be formed along a boundary surface between the upper source/drain region USD1 and the source/drain contact CA1.The semiconductor device shown in FIG. 2 to FIG. 4 may be fabricated through the fabricating process described as above.

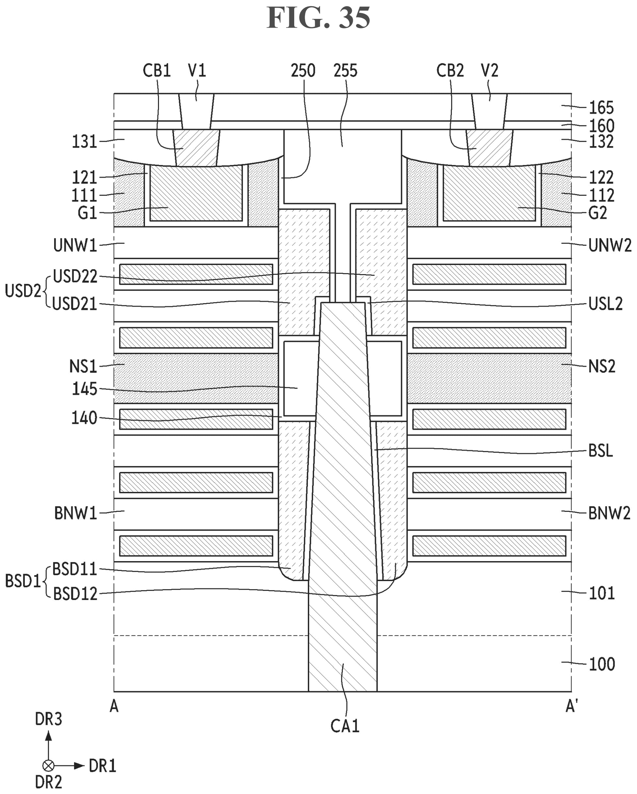

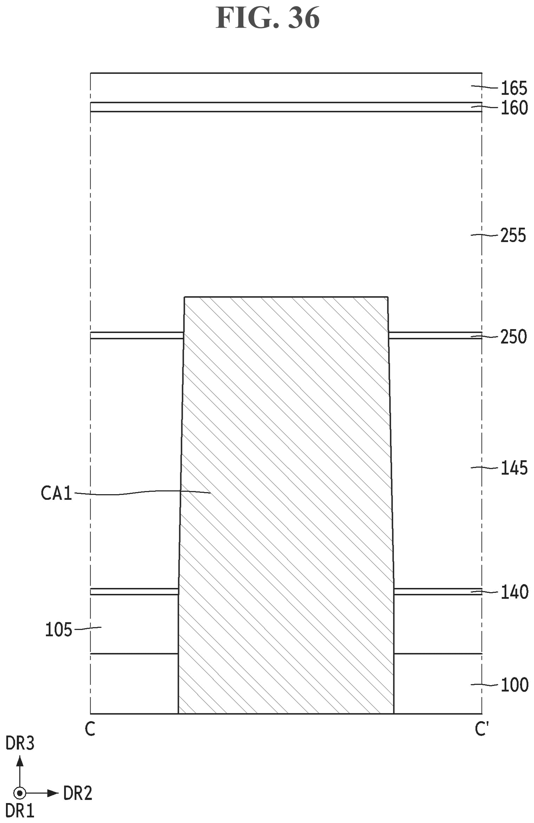

Hereinafter, a semiconductor device will be described with reference to FIGS. 35 and 36. The following description will be based on differences from the semiconductor device shown in FIGS. 1 to 4.

FIGS. 35 and 36 are cross-sectional views illustrating an example of a semiconductor device.

Referring to FIGS. 35 and 36, the semiconductor device may include a first portion USD21 and a second portion USD22, which are separated from the upper source/drain region USD2 in the first horizontal direction DR1.

For example, the first portion USD21 of the upper source/drain region USD2 may be in contact with the sidewalls of the first plurality of upper nanosheets UNW1 in the first horizontal direction DR1. The second portion USD22 of the upper source/drain region USD2 may be in contact with the sidewalls of the second plurality of upper nanosheets UNW2 in the first horizontal direction DR1. The second portion USD22 of the upper source/drain region USD2 may be spaced apart from the first portion USD21 of the upper source/drain region USD2 in the first horizontal direction DR1.

For example, at least a portion of the upper surface of the source/drain contact CA1 may be in contact with each of a second etching stop layer 250 and a second upper interlayer insulating layer 255 between the first portion USD21 of the upper source/drain region USD2 and the second portion USD22 of the upper source/drain region USD2,. For example, the upper silicide layer USL2 may be disposed along a boundary surface between the first portion USD21 of the upper source/drain region USD2 and the source/drain contact CA1. Also, the upper silicide layer USL2 may be disposed along a boundary surface between the second portion USD22 of the upper source/drain region USD2 and the source/drain contact CA1.

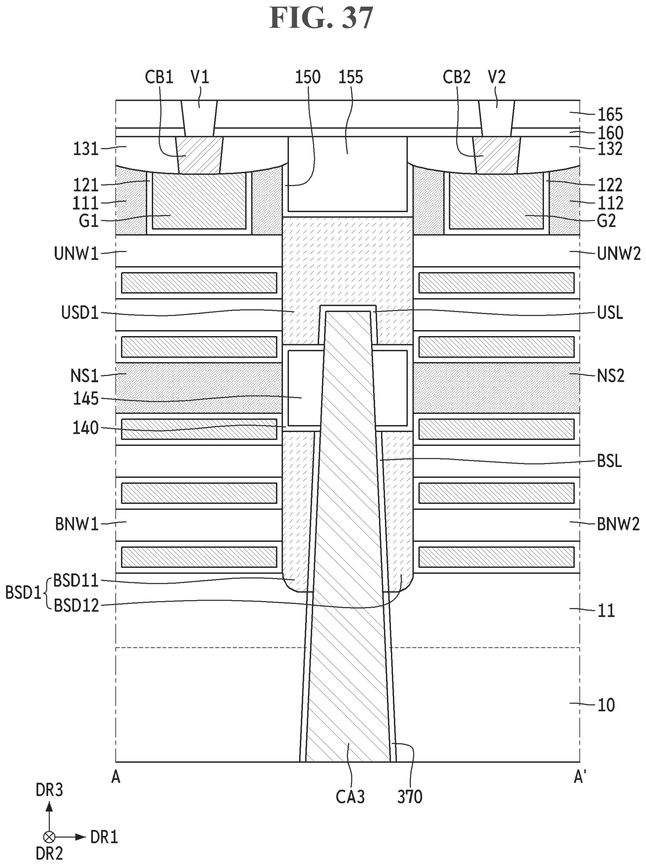

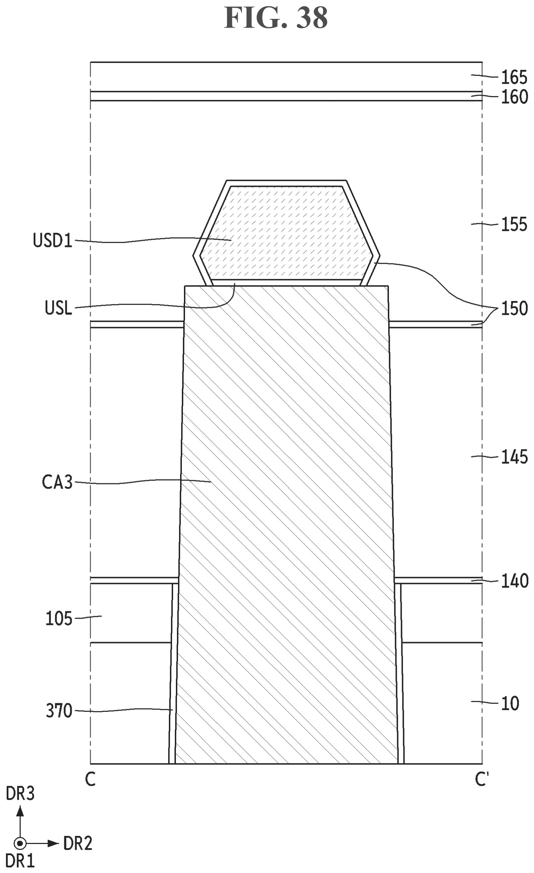

Hereinafter, a semiconductor device will be described with reference to FIGS. 37 and 38. The following description will be based on differences from the semiconductor device shown in FIGS. 1 to 4.

FIGS. 37 and 38 are cross-sectional views illustrating an example of a semiconductor device.

Referring to FIGS. 37 and 38, in the semiconductor device, an active pattern 11 may be disposed below the lower source/drain region BSD1.

For example, the active pattern 11 may be disposed below each of the lower source/drain region BSD1 and the first and second plurality of lower nanosheets BNW1 and BNW2. The active pattern 11 may extend in the first horizontal direction DR1. The lower surface of the lower source/drain region BSD1 may be in contact with an upper surface of the active pattern 11. For example, the active pattern 11 may include silicon (Si). For example, the substrate 10 may be disposed below each of the active pattern 11 and the field insulating layer 105. The upper surface of the substrate 10 may be in contact with the lower surface of each of the active pattern 11 and the field insulating layer 105. For example, the substrate 10 may include silicon (Si).

For example, a source/drain contact CA31 may extend into the upper source/drain region USD1 by passing through the substrate 10, the active pattern 11, the lower source/drain region BSD1, the first etching stop layer 140, the first upper interlayer insulating layer 145, and the second etching stop layer 150 in the vertical direction DR3. For example, a lower surface of the source/drain contact CA31 may be formed on the same plane as the lower surface of the substrate 10.

For example, an insulating liner layer 370 may be disposed between the source/drain contact CA31 and the substrate 10 and between the source/drain contact CA31 and the active pattern 11, respectively. For example, the insulating liner layer 370 may be disposed between the source/drain contact CA31 and the field insulating layer 105. For example, the insulating liner layer 370 may be formed to be conformal. For example, a lower surface of the insulating liner layer 370 may be formed on the same plane as the source/drain contact CA31. For example, an upper surface of the insulating liner layer 370 may be in contact with the lower surface of the lower silicide layer BSL. The insulating liner layer 370 may include an insulating material. For example, the insulating liner layer 370 may include at least one of silicon nitride (SiN), silicon oxynitride (SiON), silicon oxide (SiO₂), silicon oxycarbonitride (SiOCN), silicon boron nitride (SiBN), silicon oxyboron nitride (SiOBN), silicon oxycarbide (SiOC), or their combination, but of the present disclosure are not limited thereto.

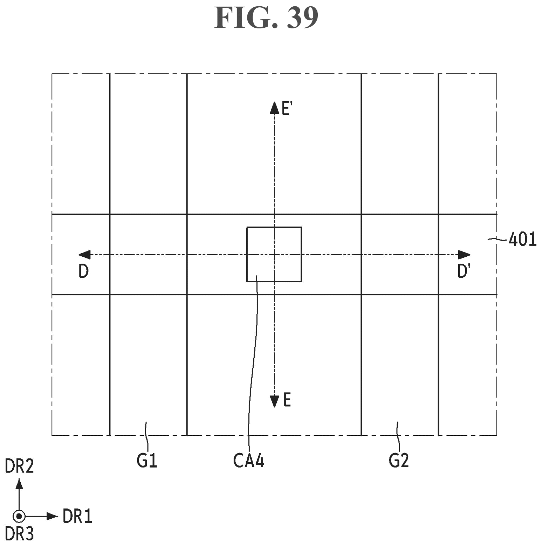

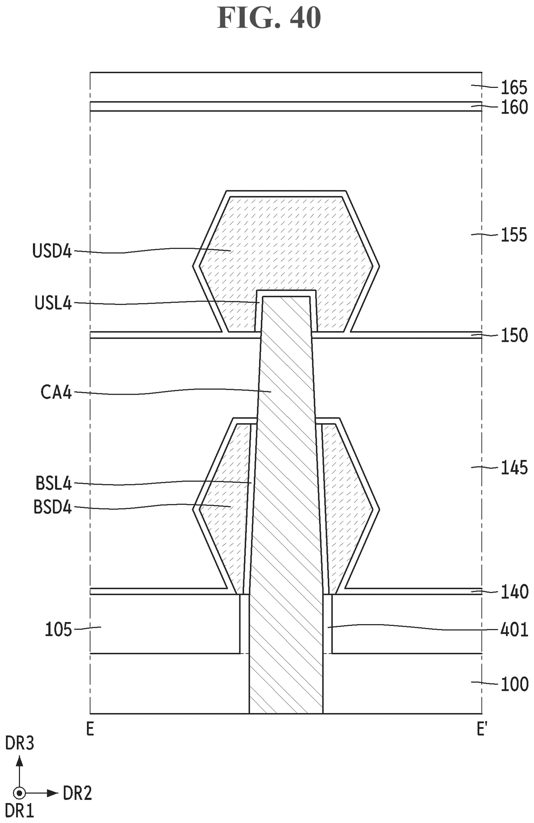

Hereinafter, a semiconductor device according to some implementations of the present disclosure will be described with reference to FIGS. 39 and 40. The following description will be based on differences from the semiconductor device shown in FIGS. 1 to 4.

FIG. 39 is a schematic layout view illustrating an example of a semiconductor device. FIG. 40 is an example cross-sectional view taken along line E-E' of FIG. 39.

Referring to FIGS. 39 and 40, in the semiconductor device according to some implementations of the present disclosure, a source/drain contact CA4 may be formed in a hole shape.

For example, a width of the source/drain contact CA4 in the second horizontal direction DR2 may be less than a width of a lower source/drain region BSD4 in the second horizontal direction DR2. The width of the source/drain contact CA4 in the second horizontal direction DR2 may be less than a width of an insulating pattern 401 in the second horizontal direction DR2. For example, at least a portion of an upper source/drain region USD4 may be disposed on respective sidewalls of the source/drain contact CA4 in the second horizontal direction DR2. For example, the lower source/drain region BSD4 may be disposed on the respective sidewalls of the source/drain contact CA4 in the second horizontal direction DR2.

For example, a lower silicide layer BSL4 may be disposed along a boundary surface between the lower source/drain region BSD4 and the source/drain contact CA4. For example, the lower silicide layer BSL4 may extend from a lower surface of the lower source/drain region BSD4 to an upper surface of the lower source/drain region BSD4 along respective sidewalls of the lower source/drain region BSD4 in the second horizontal direction DR2. An upper silicide layer USL4 may be disposed along a boundary surface between the upper source/drain region USD4 and the source/drain contact CA4.

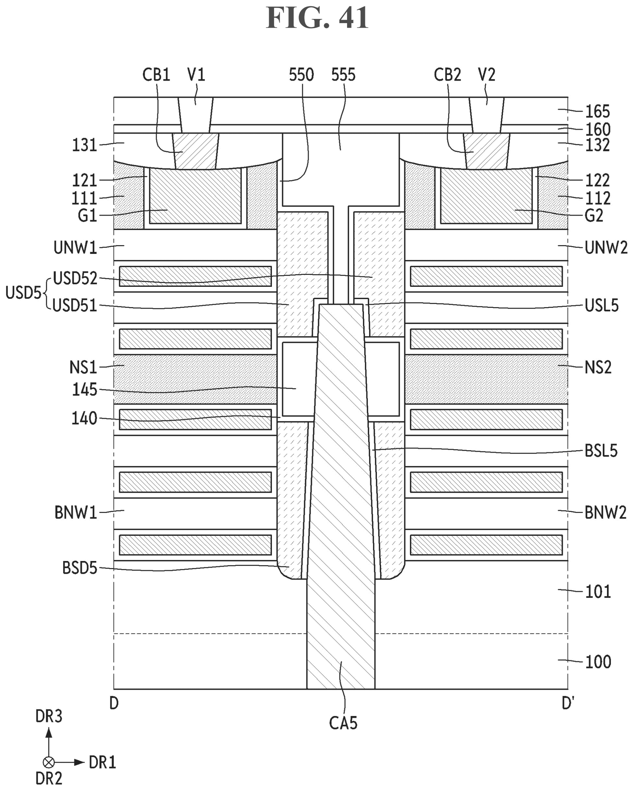

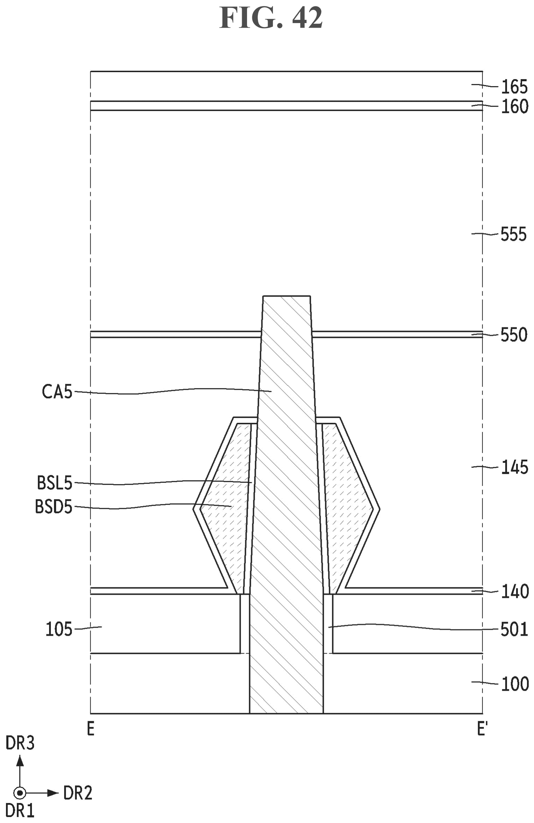

Hereinafter, a semiconductor device according to some implementations of the present disclosure will be described with reference to FIGS. 41 and 42. The following description will be based on differences from the semiconductor device shown in FIGS. 1 to 4.

FIGS. 41 and 42 are cross-sectional views illustrating an example of a semiconductor device.

Referring to FIGS. 41 and 42, the semiconductor device may include a first portion USD51 and a second portion USD52, which are separated from an upper source/drain region USD5 in the first horizontal direction DR1, and a source/drain contact CA5 may be formed in a hole shape.

For example, the first portion USD51 of the upper source/drain region USD5 may be in contact with the sidewalls of the first plurality of upper nanosheets UNW1 in the first horizontal direction DR1. The second portion USD52 of the upper source/drain region USD5 may be in contact with the sidewalls of the second plurality of upper nanosheets UNW2 in the first horizontal direction DR1. The second portion USD52 of the upper source/drain region USD5 may be spaced apart from the first portion USD51 of the upper source/drain region USD5 in the first horizontal direction DR1.

For example, at least a portion of an upper surface of the source/drain contact CA5 may be in contact with each of a second etching stop layer 550 and a second upper interlayer insulating layer 555 between the first portion USD51 of the upper source/drain region USD5 and the second portion USD52 of the upper source/drain region USD5. For example, an upper silicide layer USL5 may be disposed along a boundary surface between the first portion USD51 of the upper source/drain region USD5 and the source/drain contact CA5. In addition, the upper silicide layer USL5 may be disposed along a boundary surface between the second portion USD52 of the upper source/drain region USD5 and the source/drain contact CA5.

For example, a width of the source/drain contact CA5 in the second horizontal direction DR2 may be less than a width of a lower source/drain region BSD5 in the second horizontal direction DR2. The width of the source/drain contact CA5 in the second horizontal direction DR2 may be less than a width of an insulating pattern 501 in the second horizontal direction DR2. For example, the lower source/drain region BSD5 may be disposed on respective sidewalls of the source/drain contact CA5 in the second horizontal direction DR2.

For example, a lower silicide layer BSL5 may be disposed along a boundary surface between the lower source/drain region BSD5 and the source/drain contact CA5. For example, the lower silicide layer BSL5 may extend from a lower surface of the lower source/drain region BSD5 to an upper surface of the lower source/drain region BSD5 along respective sidewalls of the lower source/drain region BSD5 in the second horizontal direction DR2. The upper silicide layer USL5 may be disposed along a boundary surface between the upper source/drain region USD5 and the source/drain contact CA5.

In some implementations, there is provided a method for fabricating a semiconductor device, comprising forming an active pattern extending in a first horizontal direction on an upper surface of a substrate, forming a plurality of lower nanosheets, a nanosheet separation layer and a plurality of upper nanosheets, which are stacked to be spaced apart from each other in a vertical direction on an upper surface of the active pattern, forming a lower source/drain region being in contact with a sidewall of the plurality of lower nanosheets in the first horizontal direction, forming a first upper interlayer insulating layer covering the lower source/drain region, forming an upper source/drain region being in contact with a sidewall of the plurality of upper nanosheets in the first horizontal direction, the upper source/drain region spaced apart from an upper surface of the lower source/drain region in the vertical direction on an upper surface of the first upper interlayer insulating layer, and forming a source/drain contact extending into the upper source/drain region by passing through the lower source/drain region and the first upper interlayer insulating layer in the vertical direction, the source/drain contact electrically connected to each of the lower source/drain region and the upper source/drain region.

In some implementations, there is provided a method for fabricating a semiconductor device, further comprising before forming the source/drain contact, etching the substrate and the active pattern, and forming an insulating pattern in a portion in which the active pattern is etched, and forming a lower interlayer insulating layer in a portion in which the substrate is etched.

In some implementations, there is provided a method for fabricating a semiconductor device, further comprising before forming the lower source/drain region, forming a sacrificial pattern below the lower source/drain region.

In some implementations, there is provided a method for fabricating a semiconductor device, comprising wherein forming a source/drain contact comprises that the source/drain contact separates the lower source/drain region in the first horizontal direction.

In some implementations, there is provided a method for fabricating a semiconductor device, comprising wherein a width of the source/drain contact in a second horizontal direction different from the first horizontal direction is less than a width of the lower source/drain region in the second horizontal direction.

While this specification contains many specific implementation details, these should not be construed as limitations on the scope of any invention or on the scope of what may be claimed, but rather as descriptions of features that may be specific to particular implementations of particular inventions. Certain features that are described in this specification in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

Although implementations according to of the present disclosure have been described with reference to the accompanying drawings, the present disclosure is not limited to the above implementations but may be fabricated in various different forms, and those of ordinary skill in the art to which the present disclosure belongs may understand that it may be implemented in other specific forms without changing or essential features of the present disclosure. Therefore, it should be understood that the implementations described above are exemplary and not limited in all respects.

## Claims

1. A semiconductor device comprising:
a first plurality of lower nanosheets (BNW1) stacked and spaced apart from each other in a vertical direction (DR3);
a second plurality of lower nanosheets (BNW2) stacked and spaced apart from each other in the vertical direction (DR3, the second plurality of lower nanosheets (BNW2) being spaced apart from the first plurality of lower nanosheets (BNW1) in a first horizontal direction (DR1);
a first nanosheet separation layer (NS1) on the first plurality of lower nanosheets (BNW1), the first nanosheet separation layer (NS1) including a first insulating material;
a second nanosheet separation layer (NS2) on the second plurality of lower nanosheets (BNW2), the second nanosheet separation layer (NS2) being spaced apart from the first nanosheet separation layer (NS1) in the first horizontal direction (DR1), the second nanosheet separation layer (NS2) including a second insulating material;
a first plurality of upper nanosheets (UNW1) stacked and spaced apart from each other in the vertical direction (DR3) on an upper surface of the first nanosheet separation layer (NS1);
a second plurality of upper nanosheets (UNW2) spaced apart from each other in the vertical direction (DR3) on an upper surface of the second nanosheet separation layer (NS2), the second plurality of upper nanosheets (UNW2) being spaced apart from the first plurality of upper nanosheets (UNW1) in the first horizontal direction (DR1);
a lower source/drain region (BSD1; BSD4) between the first plurality of lower nanosheets (BNW1) and the second plurality of lower nanosheets (BNW2);
an upper source/drain region (USD1; USD2; USD4; USD5) between the first plurality of upper nanosheets (UNW1) and the second plurality of upper nanosheets (UNW2), the upper source/drain region (USD1; USD2; USD4; USD5) being spaced apart from the lower source/drain region (BSD1; BSD4) in the vertical direction (DR3);
a first upper interlayer insulating layer (145) between the first nanosheet separation layer (NS1) and the second nanosheet separation layer (NS2); and
a source/drain contact (CA1; CA3; CA4; CA5) extending into the upper source/drain region (USD1; USD2; USD4; USD5) by passing through the lower source/drain region (BSD1; BSD4) and the first upper interlayer insulating layer (145) in the vertical direction (DR3), the source/drain contact (CA1; CA3; CA4 CA5) being electrically connected to each of the lower source/drain region (BSD1; BSD4) and the upper source/drain region (USD1; USD2; USD4; USD5).

2. The semiconductor device of claim 1, comprising:
a first gate electrode (G1) extending in a second horizontal direction (DR2) different from the first horizontal direction (DR1), the first gate electrode (G1) surrounding the first plurality of lower nanosheets (BNW1), the first nanosheet separation layer (NS1), and the first plurality of upper nanosheets (UNW1); and
a second gate electrode (G2) extending in the second horizontal direction (DR2), the second gate electrode (G2) surrounding the second plurality of lower nanosheets (BNW2), the second nanosheet separation layer (NS2), and the second plurality of upper nanosheets (UNW2), the second gate electrode (G2) being spaced apart from the first gate electrode (G1) in the first horizontal direction (DR1).

3. The semiconductor device of claim 1 or 2, comprising:
an etching stop layer (140) between a sidewall of the first nanosheet separation layer (NS1) in the first horizontal direction (DR1) and the first upper interlayer insulating layer (145), and between a sidewall of the second nanosheet separation layer (NS2) in the first horizontal direction (DR1) and the first upper interlayer insulating layer (145).

4. The semiconductor device of any one of claims 1 to 3, wherein an upper surface of the source/drain contact (CA1; CA3; CA4; CA5) is between a lower surface of the upper source/drain region (USD1; USD2; USD4; USD5) and an upper surface of the upper source/drain region (USD1; USD2; USD4; USD5).

5. The semiconductor device of any one of claims 1 to 4, comprising:
a lower silicide layer (BSL; BSL4) along a boundary surface between the source/drain contact (CA1; CA3; CA4; CA5) and the lower source/drain region (BSD1; BSD4), the lower silicide layer (BSL) extending from a lower surface of the lower source/drain region (BSD1; BSD4) to an upper surface of the lower source/drain region (BSD1; BSD4) along a sidewall of the source/drain contact (CA1; CA3; CA4; CA5).

6. The semiconductor device of any one of claims 1 to 5, comprising:
an insulating pattern (101) below each of the lower source/drain region (BSD1), the first plurality of lower nanosheets (BNW1), and the second plurality of lower nanosheets (BNW2), the insulating pattern (101) extending in the first horizontal direction (DR1); and
a lower interlayer insulating layer (100) below the insulating pattern (101),
wherein the source/drain contact (CA1; CA5) extends through the lower interlayer insulating layer (100) and the insulating pattern (101) in the vertical direction (DR3).

7. The semiconductor device of any one of claims 1 to 6, wherein the source/drain contact (CA1; CA3; CA4; CA5) separates the lower source/drain region (BSD1) in the first horizontal direction (DR1).

8. The semiconductor device of any one of claims 1 to 7, wherein the upper source/drain region (USD2; USD5) comprises:
a first portion (USD21; USD51) contacting a sidewall of the first plurality of upper nanosheets (UNW1) in the first horizontal direction (DR1); and
a second portion (USD22; USD52) contacting a sidewall of the second plurality of upper nanosheets (UNW2) in the first horizontal direction (DR1), the second portion (USD22; USD52) being spaced apart from the first portion (USD21; USD51) in the first horizontal direction (DR1).

9. The semiconductor device of claim 8, comprising:
a second upper interlayer insulating layer (255; 555) covering the upper source/drain region (USD2; USD5) on an upper surface of the first upper interlayer insulating layer (145),
wherein at least a portion of an upper surface of the source/drain contact (CA1; CA5) contacts the second upper interlayer insulating layer (255; 555) between the first portion (USD21; USD51) of the upper source/drain region (USD2; USD5) and the second portion (USD22; USD52) of the upper source/drain region (USD2; USD5).

10. The semiconductor device of any one of claims 1 to 9, wherein a width of the source/drain contact (CA1; CA3; CA4; CA5) in a second horizontal direction (DR2) different from the first horizontal direction (DR1) is less than a width of the lower source/drain region (BSD1; BSD4; BSD5) in the second horizontal direction (DR2).

11. The semiconductor device of any one of claims 1 to 10, comprising:
an active pattern (11) below each of the lower source/drain region (BSD1), the first plurality of lower nanosheets (BNW1), and the second plurality of lower nanosheets (BNW2), the active pattern (11) extending in the first horizontal direction (DR1), the active pattern (11) including silicon, Si; and
a substrate (10) below the active pattern (11), the substrate (10) including silicon, Si,
wherein the source/drain contact (CA3) extends through the active pattern (11) and the substrate (10) in the vertical direction (DR3).

12. The semiconductor device of claim 11, comprising:
an insulating liner layer (370) between a sidewall of the source/drain contact (CA3) and the active pattern (11), and between the sidewall of the source/drain contact (CA1) and the substrate (10), the insulating liner layer (370) including a third insulating material.

13. The semiconductor device of any one of claims 1 to 12, wherein a width of a lower surface of the source/drain contact (CA1; CA3; CA4; CA5) in the first horizontal direction (DR1) is greater than a width of an upper surface of the source/drain contact (CA1) in the first horizontal direction (DR1).

14. The semiconductor device of any one of claims 1 to 13, wherein the lower source/drain region (BSD1; BSD4; BSD5), and the first and second plurality of lower nanosheets (BNW2) define a PMOS transistor, and
wherein the upper source/drain region (USD1; USD2; USD4; USD5), and the first and second plurality of upper nanosheets (UNW2) define an NMOS transistor.

15. The semiconductor device of any one of claims 1 to 14, wherein the lower source/drain region (BSD5) is on both sidewalls of the source/drain contact (CA5) in a second horizontal direction (DR2) different from the first horizontal direction (DR1).
